# EUROPEAN PATENT SPECIFICATION

(11) **EP 4 579 406 B1**
(45) Date of publication and mention of the grant of the patent: **08.07.2026**
(21) Application number: 24211445.2
(22) Date of filing: 07.11.2024
(51) Int. Cl.: G06F 3/041, G06F 3/044, H10K 59/131, H10K 59/40

(54) **TRANSPARENT DISPLAY APPARATUS**
TRANSPARENTE ANZEIGEVORRICHTUNG
APPAREIL D'AFFICHAGE TRANSPARENT

(30) Priority: 29.12.2023 KR 20230197908
(43) Date of publication of application: 02.07.2025
(73) Proprietor: LG Display Co., Ltd., Seoul 07336 (KR)
(72) Inventor: KWON, Hoiyong, 10845 Paju-si, Gyeonggi-do (KR); KIM, Youngwan, 10845 Paju-si, Gyeonggi-do (KR)
(74) Representative: Viering, Jentschura & Partner mbB Patent- und Rechtsanwälte

(56) References cited:
- EP-A1- 4 411 521
- US-A1- 2023 172 015
- US-A1- 2023 195 257

## Description

### CROSS-REFERENCE TO RELATED APPLICATIONS

This application claims priority to Korean Patent Application No. 10-2023-0197908 filed in the Republic of Korea on December 29, 2023.

### BACKGROUND

### Technical Field

The present disclosure relates to a transparent display apparatus.

### Description of the Related Art

With the advancement of the information age, the demand for a display apparatus for displaying an image has increased in various forms. Therefore, various types of display apparatuses such as a liquid crystal display (LCD) apparatus, an organic light emitting display (OLED) apparatus, a micro light emitting diode (LED) display apparatus and a quantum dot display (QD) apparatus have been recently used.

Recently, studies for a transparent display apparatus that displays an image for a user and allows the user to view objects or images, which are positioned at an opposite side thereof, by transmitting light are actively ongoing. The transparent display apparatus includes a display area, in which an image is displayed, and a non-display area, wherein the display area may include a transmissive area capable of transmitting external light and a non-transmissive area. The transparent display apparatus may have high light transmittance in the display area through the transmissive area. The transparent display apparatus may include a plurality of touch sensors and a plurality of touch sensor lines to implement a touch function.

Such a transparent display apparatus is highly likely to be used in various fields in that a user can view images and backgrounds together, but since the transparent display apparatus may be applied to various fields and used for various purposes of use, it is necessary to be manufactured in multiple types (or various sizes). However, when the transparent display apparatus is manufactured in multiple types (or various sizes), problems occur in that manufacturing cost and production energy are increased due to an increase in the number of processes.

US 2023/195257 A1 discloses a transparent display device with a touch sensor.

### SUMMARY

An aspect of the present disclosure is directed to providing a transparent display apparatus that may implement a touch sensor function.

Another aspect of the present disclosure is directed to providing a transparent display apparatus that may implement a touch sensor function and may be manufactured in multiple types (or various sizes).

The objects of the present disclosure are not limited to the aforesaid, but other objects not described herein will be clearly understood by those skilled in the art from descriptions below. According to an aspect of the present disclosure, a transparent display apparatus according to claim 1 is provided. Further embodiments are described in the dependent claims.

A transparent display apparatus according to an embodiment of the present disclosure may comprise a substrate including a non-transmissive area including a light emission area in which a light emitting element is disposed and a transmissive area, a plurality of first signal lines disposed in the non-transmissive area on the substrate and extended in a first direction, at least one second signal line disposed in the non-transmissive area on the substrate and extended in a second direction crossing the first direction, a touch sensor disposed in the transmissive area on the substrate, and at least one undercut line disposed to be adjacent to the touch sensor.

According to one or more embodiments of the present disclosure, a transparent display apparatus that may implement a touch sensor function may be provided.

According to one or more embodiments of the present disclosure, a transparent display apparatus, which may implement a touch sensor function and may be manufactured in multiple types (or various sizes), may be provided.

The effects of the present disclosure are not limited to the aforesaid, but other effects not described herein will be clearly understood by those skilled in the art from descriptions below.

The details of the present disclosure described in technical problem, technical solution, and advantageous effects do not specify essential features of claims, and thus, the scope of claims is not limited by the details described in detailed description of the invention.

### BRIEF DESCRIPTION OF THE DRAWINGS

The accompanying drawings, which are included to provide a further understanding of the disclosure and are incorporated in and constitute a part of this application, illustrate embodiments of the disclosure and together with the description serve to explain principles of the disclosure.
FIG. 1 is a view illustrating a transparent display apparatus according to the embodiment of the present disclosure.
FIG. 2 is a circuit view illustrating a subpixel of a transparent display apparatus according to the embodiment of the present disclosure.
FIG. 3 is a view illustrating an area A shown in FIG. 1 according to the embodiment of the present disclosure.
FIG. 4 is a view illustrating an area B shown in FIG. 3 according to the embodiment of the present disclosure.
FIG. 5 is a view illustrating a connection relation between a plurality of touch blocks and a plurality of touch lines according to the embodiment of the present disclosure.
FIG. 6 is a view illustrating a connection relation between a plurality of touch sensors in a single touch block according to the embodiment of the present disclosure.
FIG. 7 is a cross-sectional view taken along line I-I' shown in FIG. 4 according to the embodiment of the present disclosure.
FIG. 8 is a cross-sectional view taken along line II-II' shown in FIG. 4 according to the embodiment of the present disclosure.
FIG. 9 is a view illustrating an area B shown in FIG. 3 according to another embodiment of the present disclosure.
FIG. 10 is a cross-sectional view taken along line III-III' shown in FIG. 9 according to another embodiment of the present disclosure.
FIG. 11 is a cross-sectional view taken along line IV-IV' shown in FIG. 9 according to another embodiment of the present disclosure.
FIG. 12 is a view illustrating an area B shown in FIG. 3 according to another embodiment of the present disclosure.
FIG. 13 is a cross-sectional view taken along line V-V' shown in FIG. 12 according to another embodiment of the present disclosure.
FIG. 14 is a cross-sectional view taken along line VI-VI' shown in FIG. 12 according to another embodiment of the present disclosure.
FIG. 15 is a view illustrating an area B shown in FIG. 3 according to another embodiment of the present disclosure.
FIG. 16 is a cross-sectional view taken along line VII-VII' shown in FIG. 15 according to another embodiment of the present disclosure.
FIG. 17 is a cross-sectional view taken along line VIII-VIII' shown in FIG. 15 according to another embodiment of the present disclosure.
FIG. 18 is a view illustrating an area B shown in FIG. 3 according to another embodiment of the present disclosure.
FIG. 19 is a cross-sectional view taken along line IX-IX' shown in FIG. 18 according to another embodiment of the present disclosure.
FIG. 20 is a cross-sectional view taken along line X-X' shown in FIG. 18 according to another embodiment of the present disclosure.
FIG. 21 is a cross-sectional view illustrating a transparent display apparatus according to another embodiment of the present disclosure.
FIG. 22 is a view illustrating an area C shown in FIG. 21 according to another embodiment of the present disclosure.
FIG. 23 is a cross-sectional view taken along line XI-XI' shown in FIG. 22 according to another embodiment of the present disclosure.
FIG. 24 is a cross-sectional view taken along line XI-XI' shown in FIG. 22 according to another embodiment of the present disclosure.

Throughout the drawings and the detailed description, unless otherwise described, the same drawing reference numerals should be understood to refer to the same elements, features, and structures. The sizes, lengths, and thicknesses of layers, regions and elements, and depiction of thereof may be exaggerated for clarity, illustration, and/or convenience.

### DETAILED DESCRIPTION

Advantages and features of the present disclosure, and implementation methods thereof, are clarified through the embodiments described with reference to the accompanying drawings. The present disclosure may, however, be embodied in different forms and should not be construed as limited to the embodiments set forth herein. Rather, these embodiments are examples and are provided so that this disclosure may be thorough and complete, to assist those skilled in the art to understand the inventive concepts without limiting the protected scope of the present disclosure.

Shapes (e.g., sizes, lengths, widths, heights, thicknesses, locations, radii, diameters, and areas), dimension, ratios, angles, numbers, and the like disclosed herein, including those illustrated in the drawings are merely examples, and thus, the present disclosure is not limited to the illustrated details. Any implementation described herein as an "example" is not necessarily to be construed as preferred or advantageous over other implementations. It is, however, noted that the relative dimensions of the components illustrated in the drawings are part of the present disclosure.

When the term "comprise," "have," "include," "contain" , "constitute," or the like is used with respect to one or more elements, one or more other elements may be added unless a term such as "only" or the like is used. The terms used in the present disclosure are merely used in order to describe example embodiments, and are not intended to limit the scope of the present disclosure. The terms of a singular form may include plural forms unless the context clearly indicates otherwise.

In construing an element, the element is construed as including an error region although there is no explicit description thereof.

In describing a positional relationship, for example, when the positional order is described as "on," "above," "below," "beneath", and "next," the case of no contact therebetween may be included, unless "just" or "direct" is used.

If it is mentioned that a first element is positioned "on" a second element, it does not mean that the first element is essentially positioned above the second element in the figure. The upper part and the lower part of an object concerned may be changed depending on the orientation of the object. Consequently, the case in which a first element is positioned "on" a second element includes the case in which the first element is positioned "below" the second element as well as the case in which the first element is positioned "above" the second element in the figure or in an actual configuration.

In describing a temporal relationship, for example, when the temporal order is described as "after," "subsequent," "next," and "before," a case which is not continuous may be included, unless "just" or "direct" is used.

It will be understood that, although the terms "first," "second," etc. may be used herein to describe various elements, these elements should not be limited by these terms. These terms are only used to distinguish one element from another. For example, a first element could be termed a second element, and, similarly, a second element could be termed a first element.

In describing elements of the present disclosure, the terms "first," "second," "A," "B," "(a)," "(b)," or the like may be used. These terms are intended to identify the corresponding element(s) from the other element(s), and these are not used to define the essence, basis, order, or number of the elements.

For the expression that an element is "connected," "coupled," "attached," "adhered," or the like to another element, the element may not only be directly connected, coupled, attached, adhered, or the like to another element, but also be indirectly connected, coupled, attached, adhered, or the like to another element with one or more intervening elements disposed or interposed between the elements, unless otherwise specified.

For the expression that an element is "overlaps," or the like with another element, the element may not only directly contact, overlap, or the like with another element, but also indirectly overlap, or the like with another element with one or more intervening elements disposed or interposed between the elements, unless otherwise specified.

The term "at least one" should be understood as including any and all combinations of one or more of the associated listed items. For example, "at least one among a first element, a second element and a third element" may include all combinations of two or more elements selected from the first, second and third elements as well as each element of the first, second and third elements.

Features of various embodiments of the present disclosure may be partially or entirety coupled to or combined with each other, may be technically associated with each other, and may be variously inter-operated, linked or driven together. The embodiments of the present disclosure may be implemented or carried out independently of each other, or may be implemented or carried out together in a co-dependent or related relationship. In one or more aspects, the components of each apparatus according to various embodiments of the present disclosure are operatively coupled and configured.

In the following description, various example embodiments of the present disclosure are described in detail with reference to the accompanying drawings. With respect to reference numerals to elements of each of the drawings, the same elements may be illustrated in other drawings, and like reference numerals may refer to like elements unless stated otherwise. The same or similar elements may be denoted by the same reference numerals even though they are depicted in different drawings. In addition, for convenience of description, a scale, dimension, size, and thickness of each of the elements illustrated in the accompanying drawings may be different from an actual scale, dimension, size, and thickness, and thus, embodiments of the present disclosure are not limited to a scale, dimension, size, and thickness illustrated in the drawings.

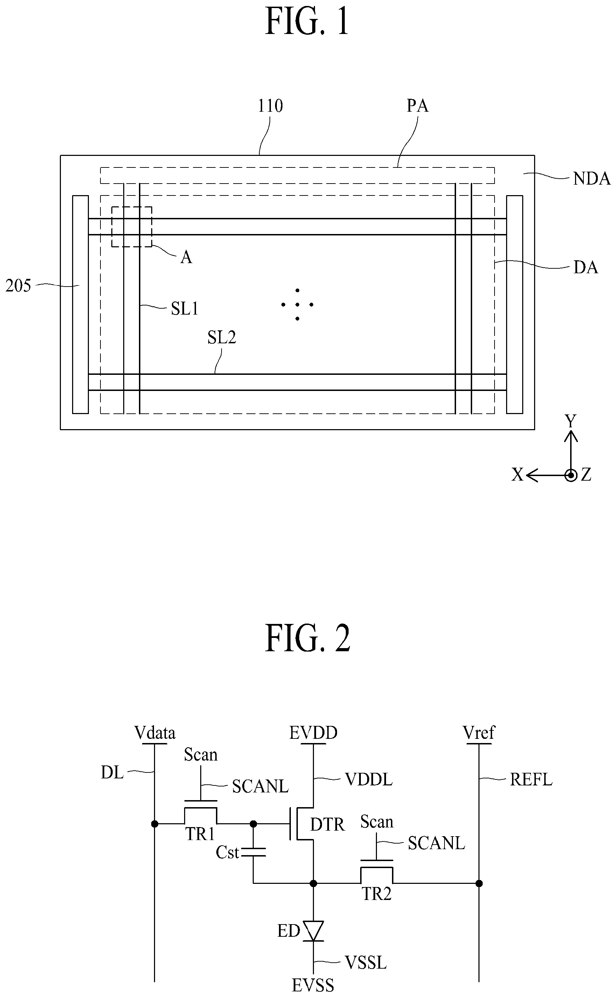

FIG. 1 is a view illustrating a transparent display apparatus according to the embodiment of the present disclosure. FIG. 2 is a circuit view illustrating a subpixel of a transparent display apparatus according to the embodiment of the present disclosure.

Hereinafter, X-axis represents a direction parallel with a scan line, Y-axis represents a direction parallel with a data line, and Z-axis represents a height direction of the transparent display apparatus.

Although the transparent display apparatus according to one embodiment of the present disclosure will be described to be implemented as an organic light emitting display (OLED) apparatus, it may be also implemented as a liquid crystal display (LCD) apparatus, a micro LED display apparatus, a quantum dot display (QD) apparatus, etc.

Referring to FIGS. 1 and 2, the transparent display apparatus according to one embodiment of the present disclosure may include a transparent display panel 110 that includes a display area DA in which pixels are provided to display an image and a non-display area NDA near the display area DA in which an image is not displayed.

The display area DA of the transparent display panel 110 may include first signal lines SL1, second signal lines SL2 and pixels, and the non-display area NDA thereof may include a pad area PA in which pads are disposed and at least one gate driver 205.

The first signal lines SL1 may be extended in a first direction (or Y-axis direction), and may cross the second signal lines SL2 in the display area DA. The second signal lines SL2 may be extended in a second direction (or X-axis direction). The pixels may be disposed in an area where the first signal line SL1 and the second signal line SL2 cross each other, and may emit predetermined light to display an image.

The gate driver 205 may be connected to a scan line to supply a scan signal. The gate driver 205 may be implemented in the non-display area NDA outside one side or both sides of the display area DA of the transparent display panel 110 in a gate driver in panel (GIP) method or a tape automated bonding (TAB) method.

A source drive integrated circuit, a circuit board or a timing controller, which is connected through a flexible circuit film, may be electrically connected to the pad area PA of the transparent display panel 110.

Referring to FIG. 2, each of the pixels includes a plurality of subpixels constituting a unit pixel, and each of the subpixels includes a circuit element having a 3T1C structure (three transistors and one capacitor) that includes a first switching transistor TR1, a second switching transistor TR2, a driving transistor DTR, and a capacitor Cst, and a light emitting element ED, but is not limited thereto. Each subpixel may further include a compensation circuit, and in this case, may have various structures such as 4T2C, 5T2C, 6T1C, 6T2C, 7T1C and 7T2C.

Each of the transistors DTR, TR1 and TR2 of each subpixel may include a gate electrode, a source electrode and a drain electrode. Since the source electrode and the drain electrode are not fixed and may be changed depending on a current direction and a voltage applied to the gate electrode, one of the source electrode and the drain electrode may be expressed as a first electrode and the other one may be expressed as a second electrode. The transistors DTR, TR1 and TR2 of each subpixel may use at least one of a polysilicon semiconductor, an amorphous silicon semiconductor and an oxide semiconductor. The transistors DTR, TR1 and TR2 may be P-type or N-type transistors, or P-type and N-type transistors may be used interchangeably.

The first switching transistor TR1 may serve to supply a data voltage Vdata supplied from a data line DL to the driving transistor DTR. For example, the first switching transistor TR1 may charge the capacitor Cst with the data voltage Vdata supplied from the data line DL. To this end, the gate electrode of the first switching transistor TR1 may be connected to a scan line SCANL (or a gate line), and a first electrode thereof may be connected to the data line DL. Also, a second electrode of the first switching transistor TR1 may be connected to one end of the capacitor Cst and the gate electrode of the driving transistor DTR.

The first switching transistor TR1 may be turned on in response to a scan signal Scan applied through the scan line SCANL (or the gate line). When the first switching transistor TR1 is turned on, the data voltage Vdata applied through the data line DL may be transferred to one end of the capacitor Cst.

The second switching transistor TR2 may serve to supply a reference voltage Vref supplied from a reference line REFL to the driving transistor DTR. For example, the gate electrode of the second switching transistor TR2 may be connected to the scan line SCANL (or the gate line), and a first electrode thereof may be connected to the reference line REFL. Also, the first electrode of the second switching transistor TR2 may be connected to a first electrode of the driving transistor DTR and the other end of the capacitor Cst.

The second switching transistor TR2 may be turned on in response to the scan signal Scan applied through the scan line SCANL (or the gate line). When the second switching transistor TR2 is turned on, the reference voltage Vref applied through the reference line REFL may be transferred to the other end of the capacitor Cst. Also, the reference voltage Vref may be applied to the source electrode of the driving transistor DTR.

The capacitor Cst may serve to maintain the data voltage Vdata supplied to the driving transistor DTR for one frame. For example, a first electrode of the capacitor Cst may be connected to the gate electrode of the driving transistor DTR, and a second electrode thereof may be connected to the source electrode of the driving transistor DTR. The capacitor Cst may store a voltage corresponding to the data voltage Vdata transferred through the first switching transistor TR1, and may turn on the driving transistor DTR with the stored voltage.

The driving transistor DTR may generate a data current from a first power source EVDD supplied from a pixel power source line VDDL (or a first power source line) to supply the generated data current to an anode electrode of the light emitting element ED. For example, the gate electrode of the driving transistor DTR may be connected to one end of the capacitor Cst, and the first electrode thereof may be connected to the pixel power source line VDDL. Also, a second electrode of the driving transistor DTR may be connected to the anode electrode of the light emitting element ED.

The light emitting element ED may include an anode electrode connected to the driving transistor DTR, a cathode electrode receiving a second power source EVSS from a common power line VSSL (or a second power line), and a light emitting layer between the anode electrode and the cathode electrode. The anode electrode is an independent electrode for each light emitting element, but the cathode electrode may be a common electrode shared by the entire light emitting elements. When a driving current is supplied from the driving transistor DTR, electrons from the cathode electrode may be injected into the light emitting layer and holes from the anode electrode may be injected into the light emitting layer, so that the light emitting element ED may allow fluorescent or phosphorescent materials to emit light through recombination of the electrons and the holes in the light emitting layer, thereby generating light with brightness proportional to a current value of the driving current.

The anode electrode of the light emitting element ED may be connected to the second electrode of the driving transistor DTR, and the cathode electrode thereof may be connected to the common power line VSSL. The light emitting element ED may emit light in response to the driving current generated by the driving transistor DTR.

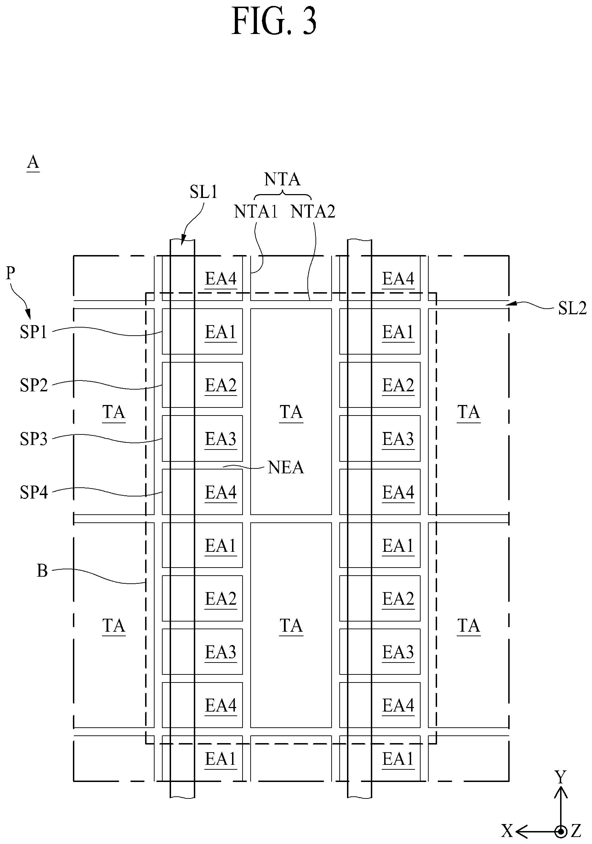

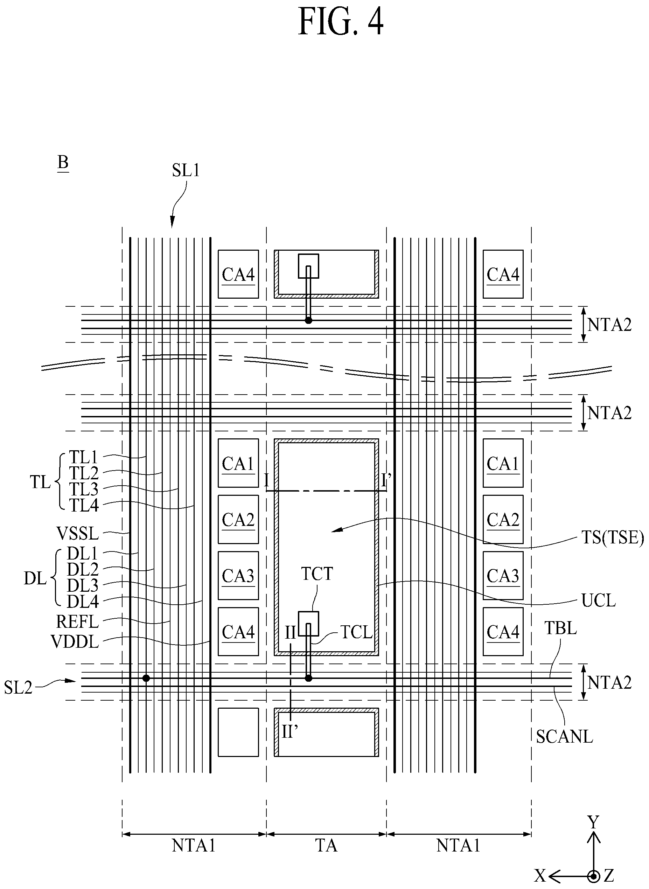

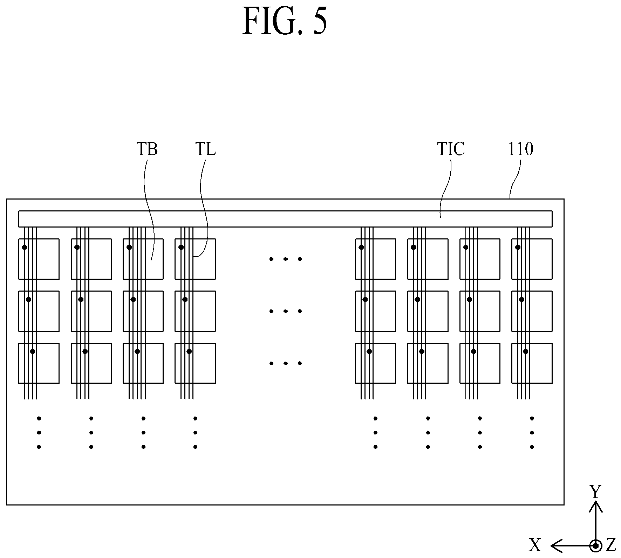

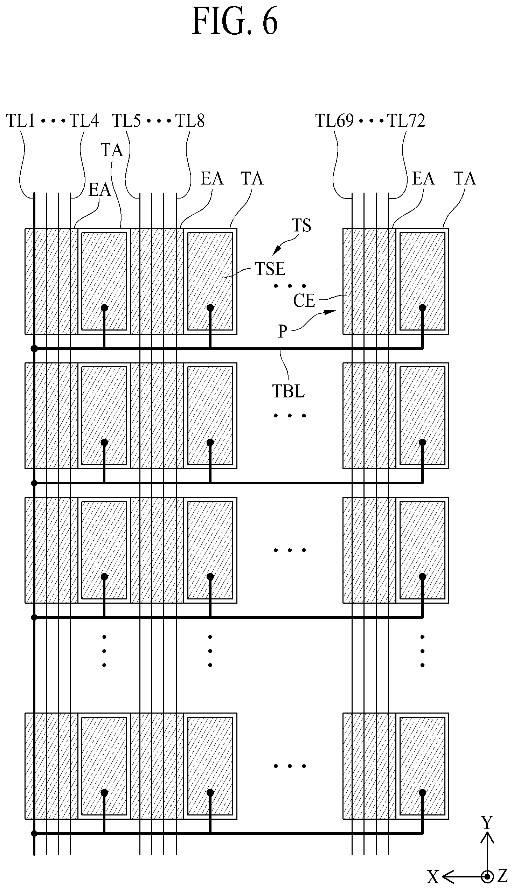

FIG. 3 is a view illustrating an area A shown in FIG. 1 according to the embodiment of the present disclosure. FIG. 4 is a view illustrating an area B shown in FIG. 3 according to the embodiment of the present disclosure. FIG. 5 is a view illustrating a connection relation between a plurality of touch blocks and a plurality of touch lines according to the embodiment of the present disclosure. FIG. 6 is a view illustrating a connection relation between a plurality of touch sensors in a single touch block according to the embodiment of the present disclosure.

Referring to FIGS. 3 to 6 in conjunction with FIGS. 1 and 2, the transparent display panel 110 according to the embodiment of the present disclosure may include a display area DA and a non-display area NDA. The display area DA may include a transmissive area TA and a non-transmissive area NTA. The transmissive area TA may be an area that transmits most of light incident from the outside, and the non-transmissive area NTA may be an area that does not transmit most of light incident from the outside. For example, the transmissive area TA may be an area having light transmittance greater than α%, and the non-transmissive area NTA may be an area having light transmittance smaller than β%. In this case, α may be a value greater than β. A user may see an object or a background, which is positioned on a back surface (or a rear surface) of the transparent display panel 110, due to the transmissive areas TA of the transparent display panel 110.

The non-transmissive area NTA may include a first non-transmissive area NTA1, a second non-transmissive area NTA2 and pixels P.

The first non-transmissive area NTA1 is extended from the display area DA in the first direction (or Y-axis direction), and may be disposed to overlap at least a portion of light emission areas EA1, EA2, EA3 and EA4. A plurality of first non-transmissive areas NTA1 may be configured. The plurality of first non-transmissive areas NTA1 may be extended in the first direction (or Y-axis direction), and may be disposed to be spaced apart from each other in the second direction (or X-axis direction). Two adjacent first non-transmissive areas NTA1 may be disposed to be spaced apart from each other with the transmissive area TA interposed therebetween. For example, the transmissive area TA may be disposed between the two adjacent first non-transmissive areas NTA1. The first signal lines SL1 extended in the first direction (or Y-axis direction) may be disposed in the first non-transmissive area NTA1. For example, the first signal lines SL1 may be disposed to overlap the first non-transmissive area NTA1.

The first signal lines SL1 may be extended from the display area DA in the first direction (or Y-axis direction), and may be disposed to at least partially overlap the light emission areas EA1, EA2, EA3 and EA4.

The first signal lines SL1 may be disposed on one side of the light emission areas EA1, EA2, EA3 and EA4. For example, the light emission areas EA1, EA2, EA3 and EA4 may be disposed in parallel along the first direction (or Y-axis direction), and the first signal lines SL1 may be disposed on a right or left side of the light emission areas EA1, EA2, EA3 and EA4. For example, the first signal lines SL1 may be disposed on the left side of the light emission areas EA1, EA2, EA3 and EA4.

A plurality of first signal lines SL1 may be provided. For example, the first signal lines SL1 may include at least one of the pixel power line VDDL, the common power line VSSL, the reference line REFL and data lines DL1, DL2, DL3 and DL4. For example, the first signal lines SL1 may further include a touch line TL, but the embodiments of the present disclosure are not limited thereto.

The pixel power line VDDL (or the first power line) may supply the first power source EVDD to the driving transistor DTR of each of subpixels SP1, SP2, SP3 and SP4 provided in the display area DA.

The common power line VSSL (or the second power line) may supply the second power source EVSS to the cathode electrode of the subpixels SP1, SP2, SP3 and SP4 provided in the display area DA. In this case, the second power source EVSS may be a common power source supplied in common to the subpixels SP1, SP2, SP3 and SP4.

The reference line REFL may supply an initialization voltage (or a reference voltage) to the driving transistor DTR of each of the subpixels SP1, SP2, SP3 and SP4 provided in the display area DA. For example, the reference line REFL may be disposed between the plurality of data lines DL1, DL2, DL3 and DL4. For example, the reference line REFL may be disposed in the middle of the plurality of data lines DL1, DL2, DL3 and DL4.

Each of the data lines DL1, DL2, DL3 and DL4 may supply the data voltage Vdata to the subpixels SP1, SP2, SP3 and SP4. For example, the first data line DL1 may supply a first data voltage to a first driving transistor of the first subpixel SP1, the second data line DL2 may supply a second data voltage to a second driving transistor of the second subpixel SP2, the third data line DL3 may supply a third data voltage to a third driving transistor of the third subpixel SP3, and the fourth data line DL4 may supply a fourth data voltage to a fourth driving transistor of the fourth subpixel SP4.

The pixel power line VDDL and the common power line VSSL may be disposed outside the plurality of data lines DL1, DL2, DL3 and DL4 and the reference line REFL. For example, the common power line VSSL may be disposed to be adjacent to the first data line DL1, and the pixel power line VDDL may be disposed to be adjacent to the fourth data line DL4, but the embodiments of the present disclosure are not limited thereto. The pixel power line VDDL may be disposed to be adjacent to the first data line DL1, and the common power line VSSL may be disposed to be adjacent to the fourth data line DL4.

At least two touch lines TL may be disposed in the first non-transmissive area NTA1. The touch line TL may be electrically connected to the touch sensors to sense a change in capacitance formed in each of the touch sensors. For example, the transparent display panel 110 according to one embodiment of the present disclosure may include a plurality of touch blocks TB, as shown in FIG. 5. Each of the plurality of touch blocks TB is a basic unit for determining a user touch position, and may include a plurality of pixels P and a plurality of transmissive areas TA disposed to correspond to the plurality of pixels P one-to-one.

In the transparent display panel 110, as shown in FIG. 6, a touch sensor TS may be disposed in the transmissive area TA. For example, each of the plurality of touch blocks TB may include 12×16 pixels P and 12×15 touch sensors TS. For example, when the pixel resolution is 1920×1080, the touch resolution may be 160×72.

The touch sensor TS may include a touch sensor electrode TSE. The touch sensor electrode TSE may be made of the same material in the same layer as the cathode electrode CE of the pixel P. For example, the touch sensor electrode TSE and the cathode electrode CE may be spaced apart from each other.

Each of the plurality of touch lines TL disposed on the transparent display panel 110 may be connected to only one of the plurality of touch blocks TB as shown in FIG. 5 to sense a change in capacitance of the touch sensors TS disposed in the connected touch block TB. For example, the plurality of touch lines TL disposed on the transparent display panel 110 may correspond to the plurality of touch blocks TB one-to-one. For example, in the transparent display panel 110, the touch line TL may be disposed in the same number as the touch block TB. For example, in the case that the number of touch blocks TB is 160×72, the touch lines TL may be also disposed as much as 160×72 and thus may be connected to a touch driver TIC. For example, although the touch line TL is shown as including four touch lines TL1, TL2, TL3 and TL4 in one first signal line SL1 in FIGS. 4 to 6, the embodiments of the present disclosure are not limited thereto, and six touch lines may be included in one first signal line SL1.

The plurality of touch sensors TS disposed in one touch block TB may be connected to one of a plurality of touch lines TL disposed in one touch block TB as shown in FIG. 6. For example, 18 first signal lines SL1 may be disposed in one touch block TB, and four touch lines TL1, TL2, TL3 and TL4 may be disposed in each of the 18 first signal lines SL1, but the embodiments of the present disclosure are not limited thereto. 12 first signal lines SL1 may be disposed in one touch block TB, and six touch lines may be disposed in each of the 12 first signal lines SL1. For example, one touch block TB may include 72 touch lines TL1 to TL72. For example, the plurality of touch sensors TS disposed in one touch block TB may be connected to one specific touch line TL1 among the 72 touch lines TL1 to TL72. For example, the specific touch line TL1 may be connected to the plurality of touch sensors TS arranged in the second direction (or X-axis direction) through touch bridge lines TBL extended in the second direction (or X-axis direction).

When the plurality of touch lines TL are disposed in the transmissive area TA in the transparent display panel 110, light transmittance may be deteriorated due to the plurality of touch lines TL. For this reason, the touch line TL may be disposed in the first non-transmissive area NTA1 rather than the transmissive area TA. The touch line TL may be disposed alternately with the data lines DL1, DL2, DL3 and DL4 and the reference line REFL as shown in FIG. 4. For example, the touch line TL may include four touch lines TL1, TL2, TL3 and TL4, and the first touch line TL1 may be disposed to be adjacent to the pixel power line VDDL or the common power line VSSL. The first touch line TL1 may be disposed between the first data line DL1 and the second data line DL2. The second touch line TL2 may be disposed between the second data line DL2 and the reference line REFL. The third touch line TL3 may be disposed between the reference line REFL and the third data line DL3. The fourth touch line TL4 may be disposed to be adjacent to the common power line VSSL or the pixel power line VDDL. The fourth touch line TL4 may be disposed between the third data line DL3 and the fourth data line DL4, but the embodiments of the present disclosure are not limited thereto.

The second non-transmissive area NTA2 may be extended from the display area DA in the second direction (or X-axis direction), and may be disposed to at least partially overlap the light emission areas EA1, EA2, EA3 and EA4. For example, the second non-transmissive area NTA2 may be extended in the second direction (or X-axis direction) between two adjacent first non-transmissive areas NTA1. A plurality of second non-transmissive areas NTA2 may be configured. The plurality of second non-transmissive areas NTA2 may be extended in the second direction (or X-axis direction), and may be disposed to be spaced apart from each other in the first direction (or Y-axis direction). The two adjacent second non-transmissive areas NTA2 may be disposed to be spaced apart from each other with the transmissive area TA interposed therebetween. For example, the transmissive area TA may be disposed between two adjacent second non-transmissive areas NTA2. The second signal lines SL2 extended in the second direction (or X-axis direction) may be disposed in the second non-transmissive area NTA2. For example, the second signal lines SL2 may be disposed to overlap the second non-transmissive area NTA2.

The second signal lines SL2 may be extended in the second direction (or X-axis direction), and may include at least one of the scan line SCANL (or the gate line) and the touch bridge line TBL. The scan line SCANL and the touch bridge line TBL may be disposed to be spaced apart from each other in the second non-transmissive area NTA2. For example, the scan line SCANL and the touch bridge line TBL may be disposed in parallel in the second direction (or X-axis direction), and may be disposed to be spaced apart from each other in the first direction (or Y-axis direction).

The scan line SCANL may be extended in the second direction (or X-axis direction), and may supply a scan signal to the subpixels SP1, SP2, SP3 and SP4 of the pixel P.

The touch bridge line TBL may connect any one of the plurality of touch lines TL to the touch sensor TS. The touch bridge line TBL may be extended from the second non-transmissive area NTA2 in the second direction (or X-axis direction), and may be configured to connect the plurality of touch lines TL disposed in the first non-transmissive area NTA1 to the touch sensor TS disposed in the transmissive area TA. For example, a touch sensor contact portion TCT may be disposed in the touch sensor TS disposed in the transmissive area TA, and the touch sensor contact portion TCT may be connected to the touch bridge line TBL through a touch connection line TCL.

The pixels P may be disposed in each crossing area where the first non-transmissive area NTA1 and the second non-transmissive area NTA2 cross each other, and may emit light to display an image. Each of the pixels P is disposed between adjacent transmissive areas TA, and the pixel P may include light emission areas EA1, EA2, EA3 and EA4 in which a light emitting element is disposed to emit light. The light emission areas EA1, EA2, EA3 and EA4 may correspond to areas, which emit light, in the pixel P. Since a size of the non-transmissive area NTA is small in the transparent display panel 110, the circuit element may be disposed to overlap the light emission areas EA1, EA2, EA3 and EA4. For example, the light emission areas EA1, EA2, EA3 and EA4 may at least partially overlap circuit areas CA1, CA2, CA3 and CA4 in which the circuit element is disposed. For example, the circuit areas CA1, CA2, CA3 and CA4 may include a first circuit area CA1 in which a circuit element connected to the first subpixel SP1 is disposed, a second circuit area CA2 in which a circuit element connected to the second subpixel SP2 is disposed, a third circuit area CA3 in which a circuit element connected to the third subpixel SP3 is disposed, and a fourth circuit area CA4 in which a circuit element connected to the fourth subpixel SP4 is disposed.

The first to fourth light emission areas EA1, EA2, EA3 and EA4 may emit light of different colors. For example, the first light emission area EA1 may emit green light, the second light emission area EA2 may emit blue light, the third light emission area EA3 may emit white light, and the fourth light emission area EA4 may emit red light, but the embodiments of the present disclosure are not limited thereto. For example, various modifications may be made in the arrangement order or arrangement form of each of the subpixels SP1, SP2, SP3 and SP4.

The circuit areas CA1, CA2, CA3 and CA4 of the subpixels SP1, SP2, SP3 and SP4 may be disposed to be adjacent to the first signal lines SL1. For example, the first signal lines SL1 may be disposed on the left side in the second direction, and each of the circuit areas CA1, CA2, CA3 and CA4 may be disposed on the right side in the second direction.

In the transparent display panel 110 according to the embodiment of the present disclosure, the plurality of subpixels SP1, SP2, SP3 and SP4 may be disposed in parallel along the first direction (or Y-axis direction). For example, the plurality of subpixels SP1, SP2, SP3 and SP4 may have a stripe shape extended in the first direction (or Y-axis direction).

The circuit areas CA1, CA2, CA3 and CA4 of the plurality of subpixels SP1, SP2, SP3 and SP4 may be disposed in parallel with the first signal line SL1 extended in the first direction (or Y-axis direction). Each of the circuit areas CA1, CA2, CA3 and CA4 may include a capacitor Cst, at least one of the thin film transistor DRT, TR1 and TR2 and a light emitting element ED, as shown in FIG. 2. For example, at least one of thin film transistor DRT, TR1 and TR2 may include a driving transistor DTR, a first switching transistor TR1 and a second switching transistor TR2. Also, the light emitting element ED may include a first electrode (or an anode electrode or a pixel electrode), a light emitting layer (or an organic light emitting layer) and a second electrode (or a cathode electrode or a common electrode).

In the transparent display panel 110 according to one embodiment of the present disclosure, the touch sensor TS may be disposed in the transmissive area TA. The touch sensor TS may be disposed in each of the plurality of transmissive areas TA. When a user contacts the touch sensor TS, there may be a change in capacitance of the touch sensor TS. For example, the touch driver TIC may be connected to the plurality of touch sensors TS through the plurality of touch lines TL to sense a change in capacitance of the plurality of touch sensors TS.

The touch sensor TS may be defined by at least one undercut line UCL disposed in the transmissive area TA. For example, the touch sensor TS may be separated from the cathode electrode of the pixel P by at least one undercut line UCL. The at least one undercut line UCL may be disposed to be adjacent to the touch sensor TS in the transmissive area TA or in the non-transmissive area NTA. At least one undercut line UCL may be configured in the form of a closed loop surrounding the area of the touch sensor TS. For example, at least one undercut line UCL may include a portion extended in the first direction (or Y-axis direction) and a portion extended in the second direction (or X-axis direction). For example, at least one undercut line UCL may be configured in the form of a closed loop in which portions parallel in the first direction and extended to be spaced apart from each other in the second direction and portions parallel in the second direction and extended to be spaced apart from each other in the first direction are connected to each other. For example, the closed loop of at least one undercut line UCL may have a rectangular shape, but the embodiments of the present disclosure are not limited thereto.

The touch sensor contact portion TCT may be disposed inside at least one undercut line UCL, and the touch line TL and the touch sensor TS may be electrically connected to each other through the touch sensor contact portion TCT. For example, the touch sensor contact portion TCT may be connected to the touch bridge line TBL connected to the touch line TL. The touch sensor contact portion TCT may be connected to the touch line TL through the touch bridge line TBL, but the embodiments of the present disclosure are not limited thereto, and the touch sensor contact portion TCT may be directly connected to the touch line TL.

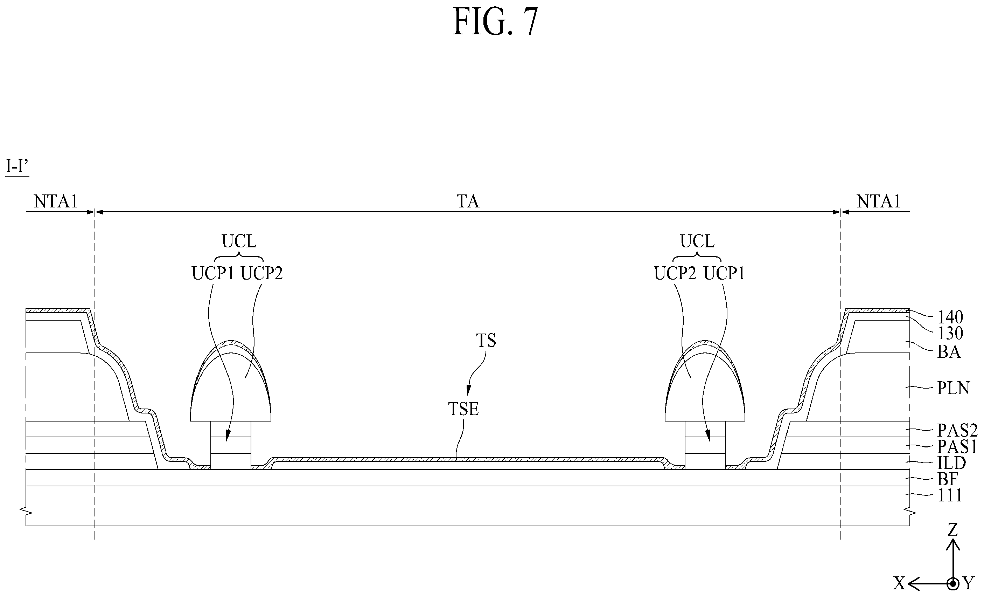

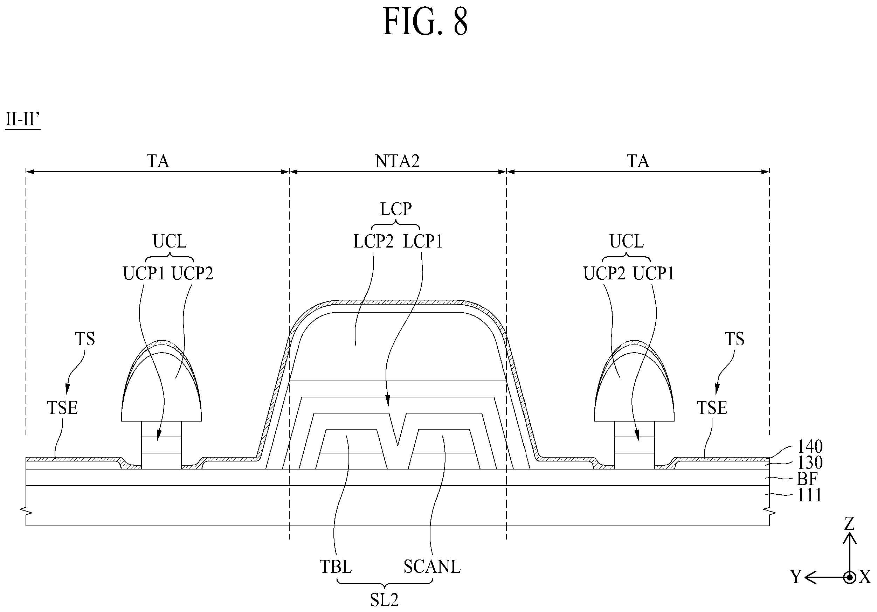

FIG. 7 is a cross-sectional view taken along line I-I' shown in FIG. 4 according to the embodiment of the present disclosure. FIG. 8 is a cross-sectional view taken along line II-II' shown in FIG. 4 according to the embodiment of the present disclosure.

Referring to FIGS. 7 and 8 in conjunction with FIG. 4, a substrate 111 of the transparent display panel 110 according to the embodiment of the present disclosure may include a non-transmissive area NTA including the light emission area EA and a transmissive area TA. The non-transmissive area NTA may include a first non-transmissive area NTA1 extended in the first direction and a second non-transmissive area NTA2 extended in the second direction.

Referring to FIG. 7, at least one undercut line UCL may be disposed in the transmissive area TA on the substrate 111. At least one undercut line UCL may be disposed to have a closed loop shape along the edge of the transmissive area TA. For example, the touch sensor TS may be provided between at least one undercut line UCL. The touch sensor TS may include a touch sensor electrode TSE. For example, at least one undercut line UCL may separate or disconnect a second electrode 140 of the light emitting element ED, so that the touch sensor electrode TSE having an island pattern may be provided to be surrounded by at least one undercut line UCL. The touch sensor TS may be disposed in the transmissive area TA, and may not overlap the non-transmissive area NTA. For example, the touch sensor TS may not overlap at least one second signal line SL2 disposed in the second non-transmissive area NTA2. The second electrode 140 may include a cathode electrode constituting the light emitting element ED in the non-transmissive area NTA and a touch sensor electrode TSE constituting the touch sensor TS in the transmissive area TA.

A buffer layer BF may be disposed on the substrate 111, at least one insulating layer including an interlayer insulating layer ILD, a first passivation layer PAS1 and a second passivation layer PAS2 may be disposed on the buffer layer BF, and a planarization layer PLN may be disposed on the second passivation layer PAS2. At least one undercut line UCL may be provided by removing at least a portion of at least one insulating layer and at least a portion of the planarization layer PLN. For example, in at least one undercut line UCL, a first undercut pattern UCP1 may be provided by removing at least a portion of the interlayer insulating layer ILD, the first passivation layer PAS1 and the second passivation layer PAS2, and a second undercut pattern UCP2 may be provided by removing at least a portion of the planarization layer PLN on the first undercut pattern UCP1. The second undercut pattern UCP2 may be formed to be more protruded than the first undercut pattern UCP1 so as to have an eave shape. An undercut area may be included below the edge of the second undercut pattern UCP2.

At least one undercut line UCL may separate or disconnect the second electrode 140 extended from the light emitting element ED, so that the touch sensor electrode TSE having an island pattern, and separated from the second electrode 140 may be provided inside at least one undercut line UCL. For example, the touch sensor electrode TSE may be disposed on an organic light emitting layer 130 separated or disconnected by at least one undercut line UCL.

Referring to FIG. 8, at least one second signal line SL2 may be disposed in the second non-transmissive area NTA2 on the substrate 111. At least one second signal line SL2 may be extended in the second direction (or X-axis direction).

At least one second signal line SL2 may include a scan line SCANL and a touch bridge line TBL. The scan line SCANL and the touch bridge line TBL may include the same material on the buffer layer BF. For example, the scan line SCANL and the touch bridge line TBL may be disposed to be parallel with each other in the second direction (or X-axis direction) and to be spaced apart from each other in the first direction (or Y-axis direction). The second non-transmissive area NTA2 may be disposed between adjacent undercut lines UCL. At least one insulating layer, which includes a buffer layer BF, an interlayer insulating layer ILD, a first passivation layer PAS1 and a second passivation layer PAS2, and a planarization layer PLN may be disposed in the second non-transmissive area on the substrate 111. For example, at least one signal line SL2 disposed in the second non-transmissive area NTA2 may be covered by at least one insulating layer and the planarization layer PLN.

At least one signal line SL2 may be protected by a line capping pattern LCP including at least one insulating layer and at least a portion of the planarization layer PLN in the second non-transmissive area NTA2 of the substrate 111. For example, the line capping pattern LCP may include a first line capping pattern LCP1 consisting of at least one insulating layer and a second line capping pattern LCP2 consisting of a planarization layer PLN on the first line capping pattern LCP1. For example, although FIG. 8 shows that the scan line SCANL and the touch bridge line TBL are disposed together in the second non-transmissive area NTA2, the touch bridge line TBL may be omitted, and only the scan line SCANL may be disposed. For example, the scan line SCANL may be protected by the line capping pattern LCP.

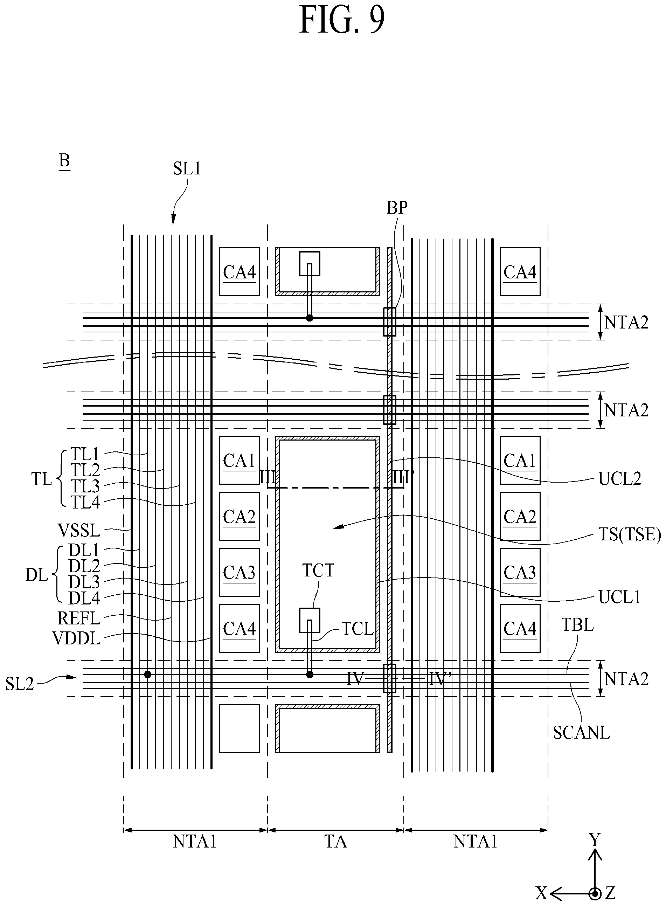

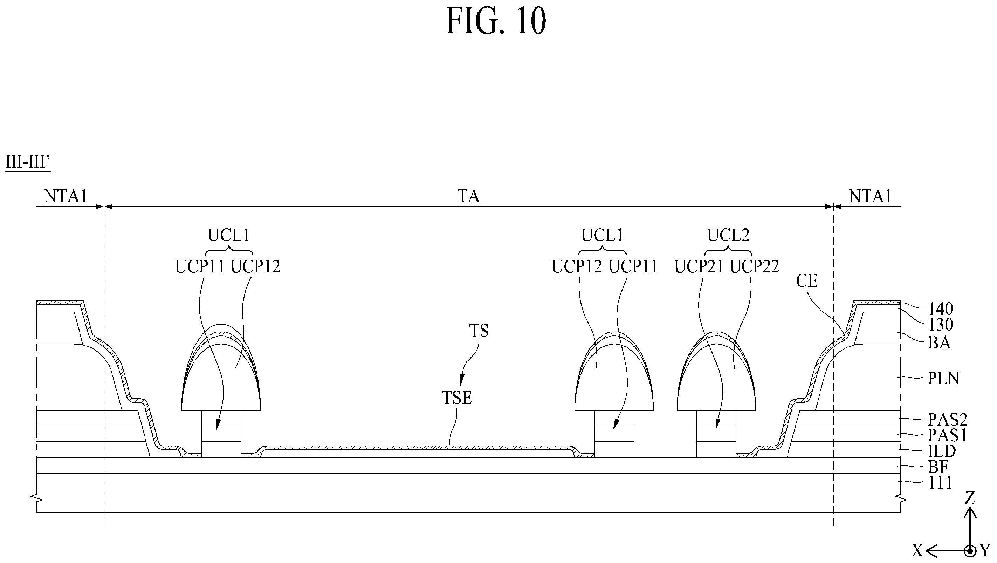

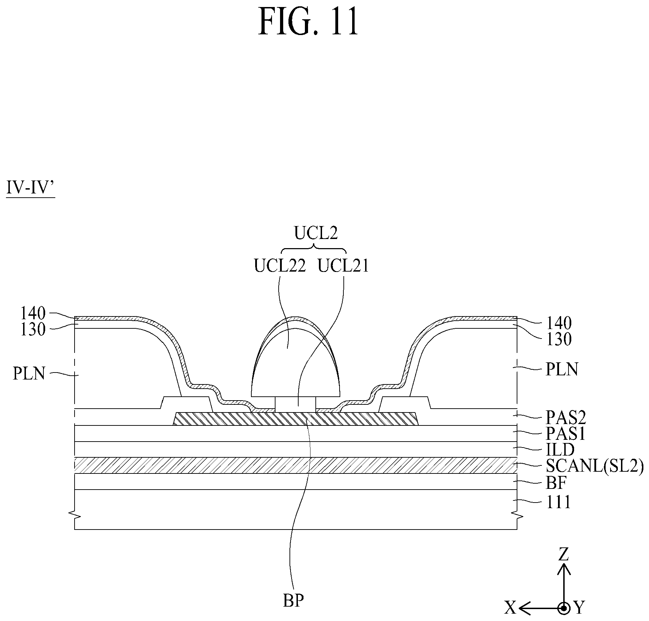

FIG. 9 is a view illustrating an area B shown in FIG. 3 according to another embodiment of the present disclosure. FIG. 10 is a cross-sectional view taken along line III-III' shown in FIG. 9 according to another embodiment of the present disclosure. FIG. 11 is a cross-sectional view taken along line IV-IV' shown in FIG. 9 according to another embodiment of the present disclosure. The elements inside the transmissive area TA in the transparent display panel 110 described with reference to FIGS. 1 to 8 are modified in FIGS. 9 to 11. Therefore, in the following description, the same reference numerals will be given to the other same elements except for the modified elements, and their redundant description will be omitted or briefly provided.

Referring to FIGS. 9 to 11, at least one undercut line UCL according to another embodiment of the present disclosure may include a first undercut line UCL1 and a second undercut line UCL2.

The first undercut line UCL1 may define the touch sensor TS in the transmissive area TA. The first undercut line UCL1 may be configured in the form of a closed loop surrounding an area of the touch sensor TS. For example, the first undercut line UCL1 may include a portion extended in the first direction (or Y-axis direction) and a portion extended in the second direction (or X-axis direction). For example, the first undercut line UCL1 may be configured in the form of a closed loop in which portions parallel in the first direction and extended to be spaced apart from each other in the second direction and portions parallel in the second direction and extended to be spaced apart from each other in the first direction are connected to each other. For example, the closed loop of the first undercut line UCL 1 may have a rectangular shape, but the embodiments of the present disclosure are not limited thereto.

The touch sensor TS may be provided inside the first undercut line UCL1. The touch sensor TS may include a touch sensor electrode TSE. The first undercut line UCL1 may separate or disconnect the second electrode 140 of the light emitting element ED, so that the touch sensor electrode TSE having an island pattern may be provided to be surrounded by at least one undercut line UCL.

The second undercut line UCL2 may be disposed in the transmissive area TA, and may be disposed to be adjacent to the touch sensor TS configured by the first undercut line UCL1. For example, the second undercut line UCL2 may be disposed to be extended in the first direction (or Y-axis direction) in the transmissive area TA. The second undercut line UCL2 may be configured to cross a plurality of transmissive areas TA arranged in parallel in the first direction. As the second undercut line UCL2 is extended in the first direction, it may cross and overlap at least a portion of at least one second signal line SL2.

According to another embodiment of the present disclosure, the second undercut line UCL2 may be disposed to be extended in the second direction (or X-axis direction). The second undercut line UCL2 may be disposed to overlap the second non-transmissive area NTA2. For example, the second undercut line UCL2 may be extended in the second direction to cross the second non-transmissive area NTA2. The second undercut line UCL2 may overlap at least one second signal line SL2 in parallel in the second non-transmissive area NTA2, but the embodiments of the present disclosure are not limited thereto.

Referring to FIG. 10, the first undercut line UCL1 and the second undercut line UCL2 may be disposed in the transmissive area TA on the substrate 111. The first undercut line UCL1 may be disposed to have a closed loop shape in the transmissive area TA. The second undercut line UCL2 may be disposed to be continuously extended in the first direction (or Y-axis direction) in the transmissive area TA. For example, the touch sensor TS may be provided between the first undercut lines UCL1. The touch sensor TS may include a touch sensor electrode TSE. For example, the first undercut line UCL1 may separate or disconnect the second electrode 140 of the light emitting element ED, so that the touch sensor electrode TSE having an island pattern may be provided to be surrounded by the first undercut line UCL1. The touch sensor TS may be disposed in the transmissive area TA, and may not overlap the non-transmissive area NTA. For example, the touch sensor TS may not overlap at least one second signal line SL2 disposed in the second non-transmissive area NTA2.

The second undercut line UCL2 disposed to be adjacent to the touch sensor TS surrounded by the first undercut line UCL1 may be disposed in the transmissive area TA on the substrate 111. The second undercut line UCL2 may be disposed to be extended in the first direction (or Y-axis direction) in the transmissive area TA.

The buffer layer BF may be disposed on the substrate 111, at least one insulating layer including an interlayer insulating layer ILD, a first passivation layer PAS1 and a second passivation layer PAS2 may be disposed on the buffer layer BF, and a planarization layer PLN may be disposed on the second passivation layer PAS2.

In the first undercut line UCL1, a first undercut pattern UCP11 may be provided by removing at least a portion of the first passivation layer PAS1 and the second passivation layer PAS2, and a second undercut pattern UCP12 may be provided by removing at least a portion of the planarization layer PLN on the first undercut pattern UCP11. The first undercut line UCL1 may separate or disconnect the second electrode 140 extended from the light emitting element ED, so that the touch sensor electrode TSE having an island pattern, and separated from the second electrode 140 may be provided inside the first undercut line UCL1. For example, the touch sensor electrode TSE may be disposed on the organic light emitting layer 130 separated or disconnected by the first undercut line UCL1.

In the second undercut line UCL2, a first undercut pattern UCP21 may be provided by removing at least a portion of the interlayer insulating layer ILD, the first passivation layer PAS1 and the second passivation layer PAS2, and a second undercut pattern UCP22 may be provided by removing at least a portion of the planarization layer PLN on the first undercut pattern UCP21.

The second undercut line UCL2 may be disposed to be extended in the first direction (or Y-axis direction) in the transmissive area TA. The second undercut line UCL2 may be configured to cross a plurality of transmissive areas TA arranged in parallel in the first direction. The second undercut line UCL2 may separate or disconnect the organic light emitting layer 130 extended from the light emitting element ED adjacent thereto. Also, as the second undercut line UCL2 is provided by removing at least a portion of the planarization layer PLN, the planarization layer PLN, which is an organic insulating layer, may be separated or disconnected. Therefore, the second undercut line UCL2 may form a boundary line in which the organic light emitting layer 130 and the planarization layer PLN, which may serve as a moisture permeation path, are continuously removed in the first direction (or Y-axis direction), and permeation of moisture into one side or the other side based on the boundary line by the second undercut line UCL2 may be avoided.

Referring to FIG. 11, at least a portion of the second undercut line UCL2 may be disposed in the non-transmissive area NTA on the substrate 111. For example, as the second undercut line UCL2 is extended continuously in the first direction, at least a portion of the second undercut line UCL2 may be disposed to cross the second non-transmissive area NTA2. The second undercut line UCL2 may cross and overlap at least one second signal line SL2 disposed in the second non-transmissive area NTA2.

A block pattern BP may be disposed at a portion where the second undercut line UCL2 and at least one second signal line SL2 cross each other. For example, the block pattern BP may be formed at the portion where the second undercut line UCL2 and at least one second signal line SL2 cross each other.

The block pattern BP is to prevent the second signal line SL2 from being damaged from an etchant used when the second undercut line UCL2 is formed. For example, the block pattern BP may be formed between the second undercut line UCL2 and at least one second signal line SL2. The block pattern BP may be formed on the first passivation layer PAS1. For example, the block pattern BP may be formed of the same material as that of other signal line formed on the first passivation layer PAS1.

In the transparent display panel 110 according to another embodiment of the present disclosure, at least one undercut line UCL1 or UCL2 is provided in the transmissive area TA, so that the touch sensor TS may be provided in the transmissive area TA, and a boundary line in which the organic light emitting layer 130 and the planarization layer PLN, which may be a moisture permeation path, are continuously removed in one side direction (e.g., the first direction or the second direction) may be formed. Therefore, the outside of the boundary line by at least one undercut line UCL1 or UCL2 may be a cutting possible area capable of preventing moisture permeation toward the pixel P even though it is cut (or separated). Therefore, in the transparent display panel 110 according to another embodiment of the present disclosure, the cutting possible area by at least one undercut line UCL1 or UCL2 may be provided in the transmissive area TA, so that a cuttable transparent display panel, which may be manufactured by being divided into various sizes depending on the field to which the transparent display panel 110 is applied and the usage thereof, may be implemented or realized.

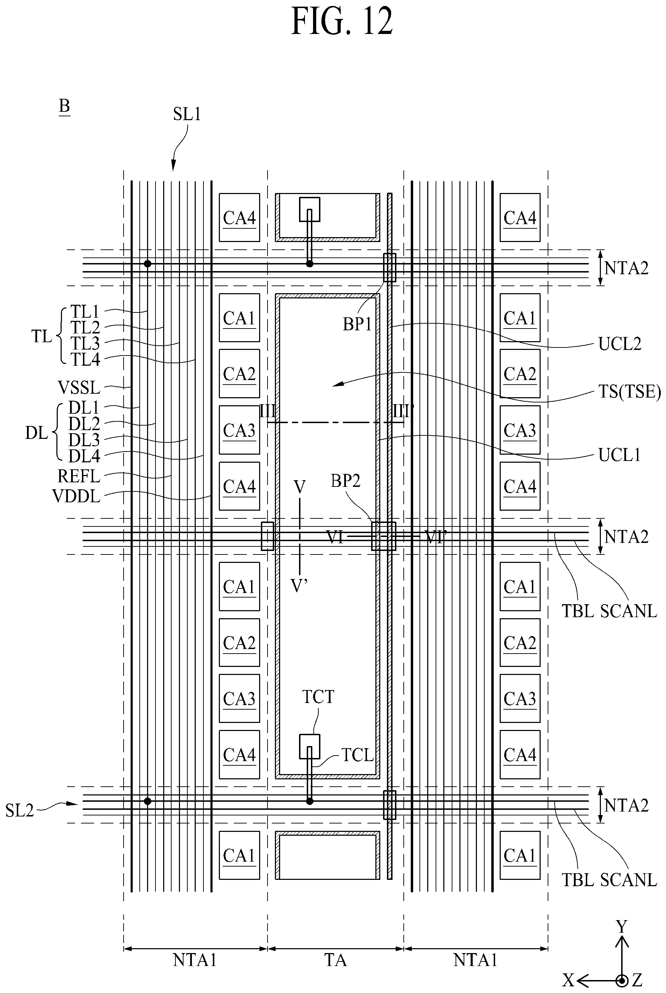

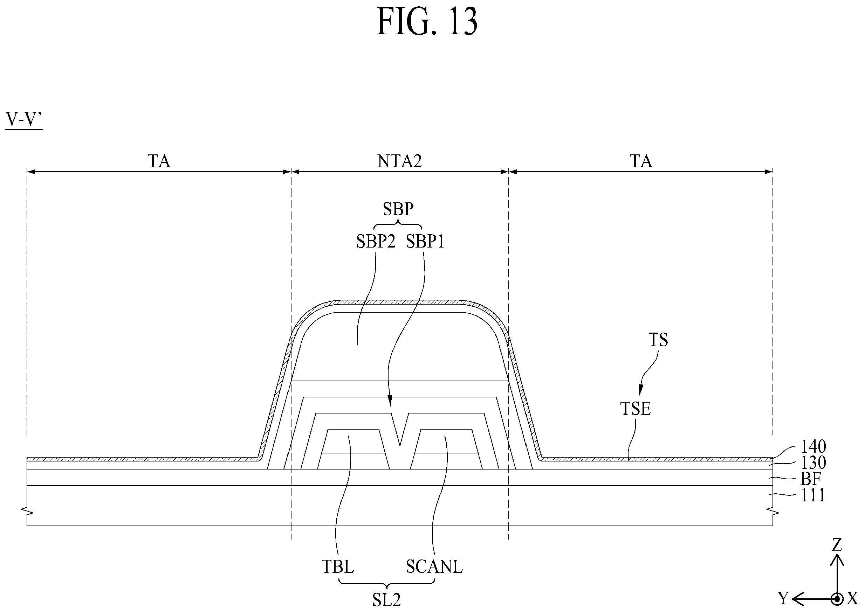

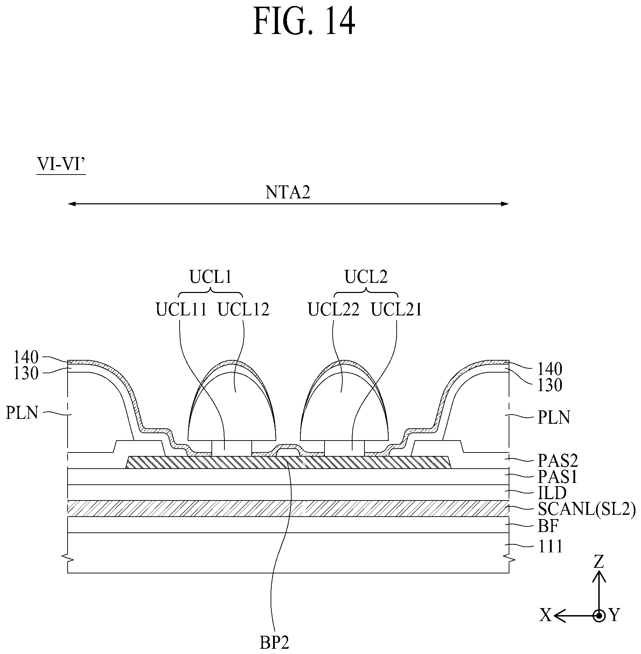

FIG. 12 is a view illustrating an area B shown in FIG. 3 according to another embodiment of the present disclosure. FIG. 13 is a cross-sectional view taken along line V-V' shown in FIG. 12 according to another embodiment of the present disclosure. FIG. 14 is a cross-sectional view taken along line VI-VI' shown in FIG. 12 according to another embodiment of the present disclosure. The elements of the undercut line in the transparent display panel 110 described with reference to FIGS. 1 to 11 are modified in FIGS. 12 to 14. Therefore, in the following description, the same reference numerals will be given to the other same elements except for the modified elements, and their redundant description will be omitted or briefly provided. Meanwhile, since the line III-III' shown in FIG. 12 is substantially the same as that shown in FIG. 10, its view will be omitted and its redundant description will be omitted or briefly provided.

Referring to FIGS. 12 to 14, at least one undercut line UCL according to another embodiment of the present disclosure may include a first undercut line UCL1 and a second undercut line UCL2.

The first undercut line UCL1 may define the touch sensor TS in the transmissive area TA. The first undercut line UCL1 may be disposed in at least two transmissive areas TA adjacent to each other in the first direction (or Y-axis direction). For example, the first undercut line UCL1 may define the touch sensor TS in two transmissive areas TA adjacent to each other in the first direction (or Y-axis direction). The first undercut line UCL1 may be configured in the form of a closed loop surrounding an area of the touch sensor TS. For example, the first undercut line UCL1 may include a portion extended to cross the transmissive areas TA adjacent to each other in the first direction (or Y-axis direction) and the second non-transmissive area NTA2 between the adjacent transmissive areas TA and a portion extended in the second direction (or X-axis direction). For example, the first undercut line UCL1 may be configured in the form of a closed loop in which portions parallel in the first direction and spaced apart from each other in the second direction and extended to cross the adjacent transmissive areas TA and the second non-transmissive area NTA2 between the adjacent transmissive areas TA and portions parallel in the second direction and extended to be spaced apart from each other in the first direction are connected to each other. For example, the closed loop of the first undercut line UCL1 may have a rectangular shape, but the embodiments of the present disclosure are not limited thereto.

The second undercut line UCL2 may be disposed in the transmissive area TA, and may be disposed to be adjacent to the touch sensor TS configured by the first undercut line UCL1. For example, the second undercut line UCL2 may be disposed to be extended in the first direction (or Y-axis direction) in the transmissive area TA. The second undercut line UCL2 may be configured to cross a plurality of transmissive areas TA arranged in parallel in the first direction. As the second undercut line UCL2 is extended in the first direction, it may cross and overlap at least a portion of at least one second signal line SL2. The block pattern BP may include a first block pattern BP1 and second block pattern BP2.

Referring to FIG. 13, at least one second signal line SL2 may be disposed in the second non-transmissive area NTA2 on the substrate 111. At least one second signal line SL2 may be extended in the second direction (or X-axis direction).

At least one second signal line SL2 may include a scan line SCANL and a touch bridge line TBL. The scan line SCANL and the touch bridge line TBL may include the same material on the buffer layer BF.

At least one signal line SL2 may be covered by a touch sensor bridge pattern SBP consisting of at least a portion of at least one insulating layer and at least a portion of the planarization layer PLN in the second non-transmissive area NTA2 of the substrate 111. The at least one second signal line SL2 may be interposed between at least two transmissive areas adjacent to each other in the first direction by the touch sensor bridge pattern SBP.

The touch sensor bridge pattern SBP may protect at least one signal line SL2, and may be configured to provide a gentle step difference so that the touch sensor electrode TSE is neither separated nor disconnected from the second non-transmissive area NTA2. For example, the touch sensor bridge pattern SBP may include a first touch sensor bridge pattern SBP1 consisting of at least one insulating layer and a second touch sensor bridge pattern SBP2 consisting of the planarization layer PLN on the first touch sensor bridge pattern SBP1. The first touch sensor bridge pattern SBP1 and the second touch sensor bridge pattern SBP2 may providing a gentle step difference while covering and protecting at least one signal line SL2, so that the touch sensor electrode TSE may be configured to cross the second non-transmissive area NTA2 between the adjacent transmissive areas TA without being separated or disconnected.

Referring to FIG. 14, at least a portion of each of the first undercut line UCL1 and the second undercut line UCL2 may be disposed in the non-transmissive area NTA on the substrate 111. For example, the first undercut line UCL1 may span the adjacent transmissive areas TA, and as the second undercut line UCL2 is extended continuously in the first direction, at least a portion of each of the first undercut line UCL1 and the second undercut line UCL2 may be disposed to cross the second non-transmissive area NTA2. The first undercut line UCL1 and the second undercut line UCL2 may cross and overlap at least one second signal line SL2 disposed in the second non-transmissive area NTA2.

A block pattern BP may be disposed at a portion where the first undercut line UCL1 and the second undercut line UCL2 cross at least one second signal line SL2. For example, the block pattern BP may be formed at the portion where the first undercut line UCL1 and the second undercut line UCL2 cross at least one second signal line SL2.

The block pattern BP is to prevent the second signal line SL2 from being damaged from an etchant used when the first undercut line UCL1 and the second undercut line UCL2 are formed. For example, the block pattern BP may be formed between the first undercut line UCL1 and the second undercut line UCL2 and at least one second signal line SL2. The block pattern BP may be formed on the first passivation layer PAS1. For example, the block pattern BP may be formed of the same material as that of other signal line formed on the first passivation layer PAS1.

In the transparent display panel 110 according to another embodiment of the present disclosure, the first undercut line UCL1 surrounding at least one of adjacent transmissive areas TA and the second undercut line UCL2 crossing the plurality of transmissive areas TA are provided, so that the touch sensor TS having an enlarged area may be provided in the adjacent transmissive areas TA, and a boundary line in which the organic light emitting layer 130 and the planarization layer PLN, which may be a moisture permeation path, are continuously removed in one side direction (e.g., the first direction or the second direction) may be formed. Therefore, the outside of the boundary line by the first and second undercut lines UCL1 and UCL2 may be a cutting possible area capable of preventing moisture permeation toward the pixel P even though it is cut (or separated). Therefore, in the transparent display panel 110 according to another embodiment of the present disclosure, the cutting possible area by the first and second undercut lines UCL1 and UCL2 may be provided in the transmissive area TA, so that a cuttable transparent display panel, which may be manufactured by being divided into various sizes depending on the field to which the transparent display panel 110 is applied and the usage thereof, may be implemented or realized.

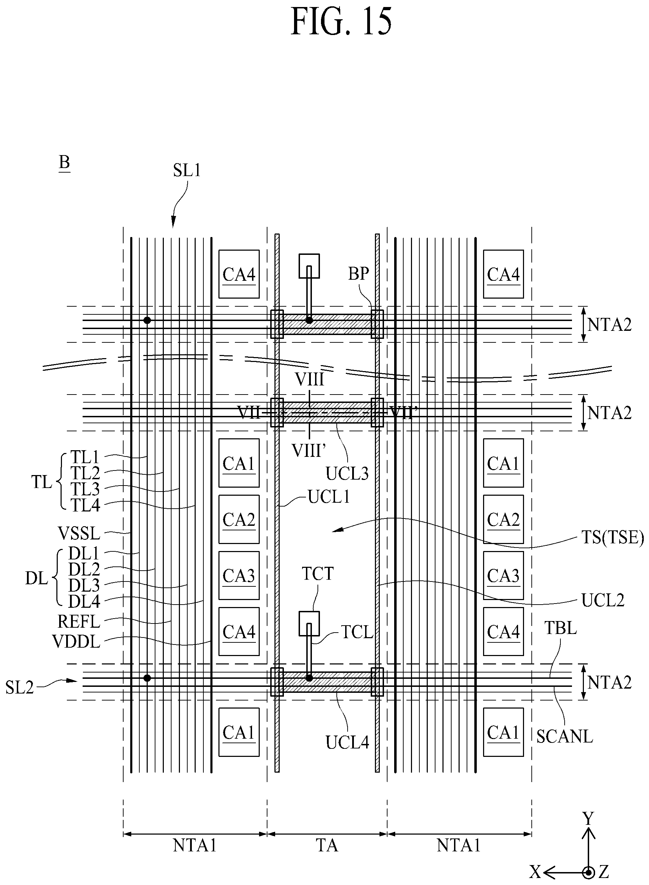

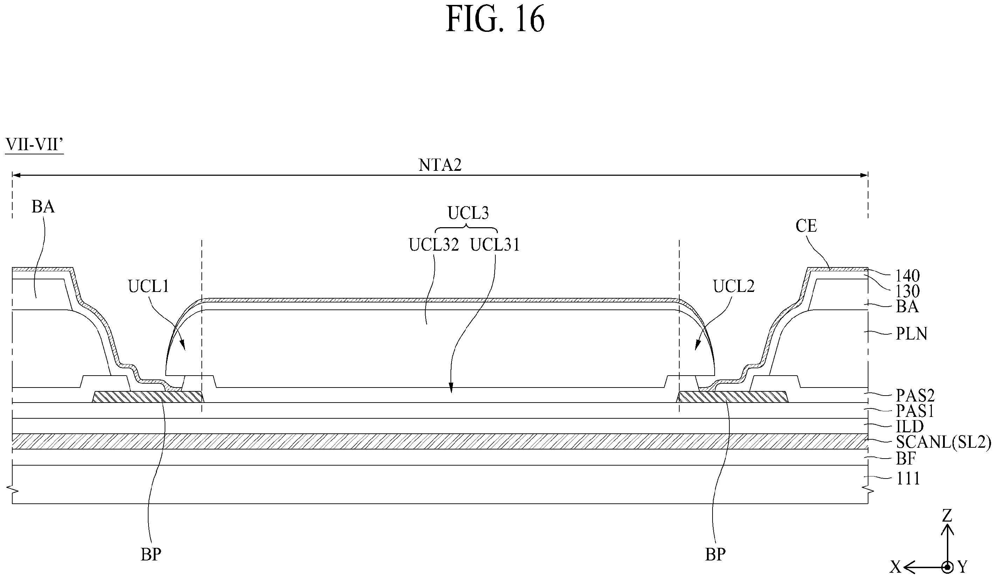

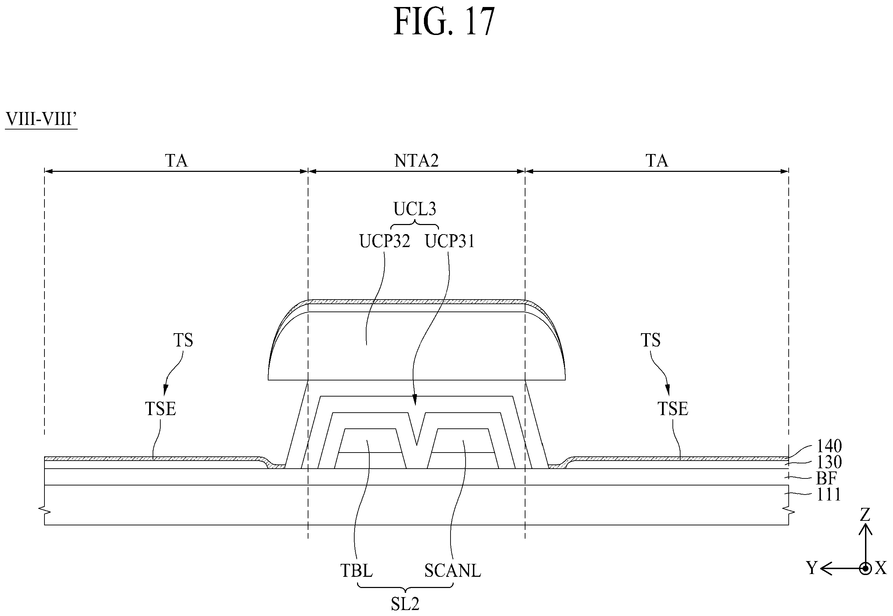

FIG. 15 is a view illustrating an area B shown in FIG. 3 according to another embodiment of the present disclosure. FIG. 16 is a cross-sectional view taken along line VII-VII' shown in FIG. 15 according to another embodiment of the present disclosure. FIG. 17 is a cross-sectional view taken along line VIII-VIII' shown in FIG. 15 according to another embodiment of the present disclosure. The elements of the undercut line in the transparent display panel 110 described with reference to FIGS. 1 to 14 are modified in FIGS. 15 to 17. Therefore, in the following description, the same reference numerals will be given to the other same elements except for the modified elements, and their redundant description will be omitted or briefly provided.

Referring to FIGS. 15 to 17, at least one undercut line UCL according to another embodiment of the present disclosure may include a plurality of undercut lines UCL1, UCL2, UCL3 and UCL4. The plurality of undercut lines UCL1, UCL2, UCL3 and UCL4 may include a first undercut line UCL1, a second undercut line UCL2, a third undercut line UCL3 and a fourth undercut line UCL4.

The first undercut line UCL1 may be extended continuously in the first direction (or Y-axis direction) in the transmissive area TA. For example, the first undercut line UCL1 may be disposed on one side (or left side) in the first direction of the transmissive area TA. The second undercut line UCL2 may be extended continuously in the first direction (or Y-axis direction) in the transmissive area TA. For example, the second undercut line UCL2 may be disposed on the other side (or right side) in the first direction of the transmissive area TA.

The first undercut line UCL1 and the second undercut line UCL2 may be spaced apart from each other in the second direction (or X-axis direction) with a predetermined area of the transmissive area TA, which is interposed therebetween, and may be extended in parallel in the first direction (or Y-axis direction). For example, the touch sensor TS or the touch sensor electrode TSE may be provided between the first undercut line UCL1 and the second undercut line UCL2. For example, the first undercut line UCL1 and the second undercut line UCL2 may be configured to cross the transmissive areas TA disposed in parallel in the first direction (or Y-axis direction). The first undercut line UCL1 and the second undercut line UCL2 may be configured to cross the second non-transmissive area NTA2 between the transmissive areas TA. The first undercut line UCL1 and the second undercut line UCL2 may cross and overlap at least one second signal line SL2 disposed in the second non-transmissive area NTA2.

The third undercut line UCL3 may be disposed between the first undercut line UCL1 and the second undercut line UCL2. The third undercut line UCL3 may be connected to each of the first undercut line UCL1 and the second undercut line UCL2. For example, the third undercut line UCL3 may be disposed on one side (or upper side) of one transmissive area TA between the first undercut line UCL1 and the second undercut line UCL2.

The fourth undercut line UCL4 may be disposed between the first undercut line UCL1 and the second undercut line UCL2. The fourth undercut line UCL4 may be connected to each of the first undercut line UCL1 and the second undercut line UCL2. For example, the fourth undercut line UCL4 may be disposed on the other side (or lower side) of one transmissive area TA between the first undercut line UCL1 and the second undercut line UCL2.

The third undercut line UCL3 and the fourth undercut line UCL4 may be spaced apart from each other in the first direction (or Y-axis direction) with one transmissive area TA interposed therebetween, and may be extended in parallel in the second direction (or X-axis direction). For example, the touch sensor TS or the touch sensor electrode TSE may be provided between the third undercut line UCL3 and the fourth undercut line UCL4. For example, the third undercut line UCL3 and the fourth undercut line UCL4 may be connected to each of the first undercut line UCL1 and the second undercut line UCL2 with a predetermined area of the transmissive area TA, which is interposed therebetween. The third undercut line UCL3 and the fourth undercut line UCL4 may be disposed to overlap the second non-transmissive area NTA2. The third undercut line UCL3 and the fourth undercut line UCL4 may overlap in parallel with at least one second signal line SL2 disposed in the second non-transmissive area NTA2. A touch sensor bridge pattern may be interposed between the third undercut line UCL3 and the fourth undercut line UCL4 and overlapped with the at least one second signal line SL2 in parallel. One end and the other end of the touch sensor bridge pattern may be spaced apart from the first undercut line UCL1 and the second undercut line UCL2.

The first to fourth undercut lines UCL1, UCL2, UCL3 and UCL4 may be connected to each other to form a closed loop shape. For example, the first to fourth undercut lines UCL1, UCL2, UCL3 and UCL4 may have a rectangular shape, but the embodiments of the present disclosure are not limited thereto.

Referring to FIG. 16, the third undercut line UCL3 may be disposed in the second non-transmissive area NTA2 on the substrate 111. Also, the fourth undercut line UCL4 may be disposed in the second non-transmissive area NTA2 on the substrate 111.

The third undercut line UCL3 may be disposed in parallel with at least one signal line SL2 in the second non-transmissive area NTA2 on the substrate 111. For example, the third undercut line UCL3 may overlap at least one signal line SL2 in parallel. The third undercut line UCL3 may overlap at least one of the scan line SCANL and the touch bridge line TBL in parallel.

One end and the other end of the third undercut line UCL3 may be connected to the first undercut line UCL1 and the second undercut line UCL2. For example, one end of the third undercut line UCL3 may be connected to the first undercut line UCL1, and the other end of the third undercut line UCL3 may be connected to the second undercut line UCL2. The first undercut line UCL1 and the second undercut line UCL2, which are connected to the third undercut line UCL3, may cross and overlap at least one second signal line SL2.

The block pattern BP may be disposed at a portion where the first to fourth undercut lines UCL1, UCL2, UCL3 and UCL4 cross at least one second signal line SL2.

The block pattern BP is to prevent the second signal line SL2 from being damaged from an etchant used when the first to fourth undercut lines UCL1, UCL2, UCL3 and UCL4 are formed. For example, the block pattern BP may be formed between the first to fourth undercut lines UCL1, UCL2, UCL3 and UCL4 and at least one second signal line SL2. The block pattern BP may be formed on the first passivation layer PAS1. For example, the block pattern BP may be formed of the same material as that of other signal line formed on the first passivation layer PAS1.

Referring to FIG. 17, the third undercut line UCL3 may be disposed in the second non-transmissive area NTA2 on the substrate 111. Also, the fourth undercut line UCL4 may be disposed in the second non-transmissive area NTA2 on the substrate 111.

In the third undercut line UCL3, a first undercut pattern UCP31 may be provided by removing at least a portion of the interlayer insulating layer ILD, the first passivation layer PAS1 and the second passivation layer PAS2, and a second undercut pattern UCP32 may be provided by removing at least a portion of the planarization layer PLN on the first undercut pattern UCP31.

The first undercut pattern UCP31 may be provided to cover at least one second signal line SL2 disposed in the second non-transmissive area NTA2. The second undercut pattern UCP32 may have an eave structure that is more protruded than the first undercut pattern UCP31. An undercut area may be included below the edge of the second undercut pattern UCP32.

The third undercut line UCL3 may separate or disconnect the organic light emitting layer 130 and the second electrode 140, which are extended to the second non-transmissive area NTA2 and the adjacent transmissive areas TA, so that the touch sensor electrode TSE having an island pattern, separated from the second electrode 140 may be provided in each of the adjacent transmissive areas TA.

In the transparent display panel 110 according to another embodiment of the present disclosure, the plurality of undercut lines UCL1, UCL2, UCL3 and UCL4 may be provided in the transmissive area TA, so that the touch sensor TS may be provided in the transmissive area TA, and a boundary line in which the organic light emitting layer 130 and the planarization layer PLN, which may be a moisture permeation path, are continuously removed in one side direction (e.g., the first direction or the second direction) may be formed. Therefore, the outside of the boundary line by the plurality of undercut lines UCL1, UCL2, UCL3 and UCL4 may be a cutting possible area capable of preventing moisture permeation toward the pixel P even though it is cut (or separated). Therefore, in the transparent display panel 110 according to another embodiment of the present disclosure, the cutting possible area by the plurality of undercut lines UCL1, UCL2, UCL3 and UCL4 may be provided in the transmissive area TA, so that a cuttable transparent display panel, which may be manufactured by being divided into various sizes depending on the field to which the transparent display panel 110 is applied and the usage thereof, may be implemented or realized.

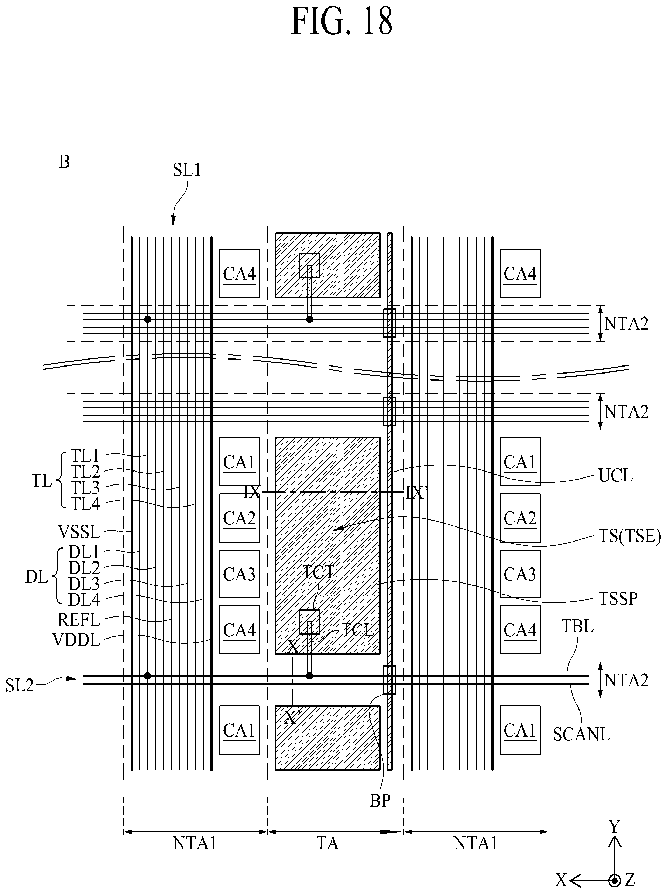

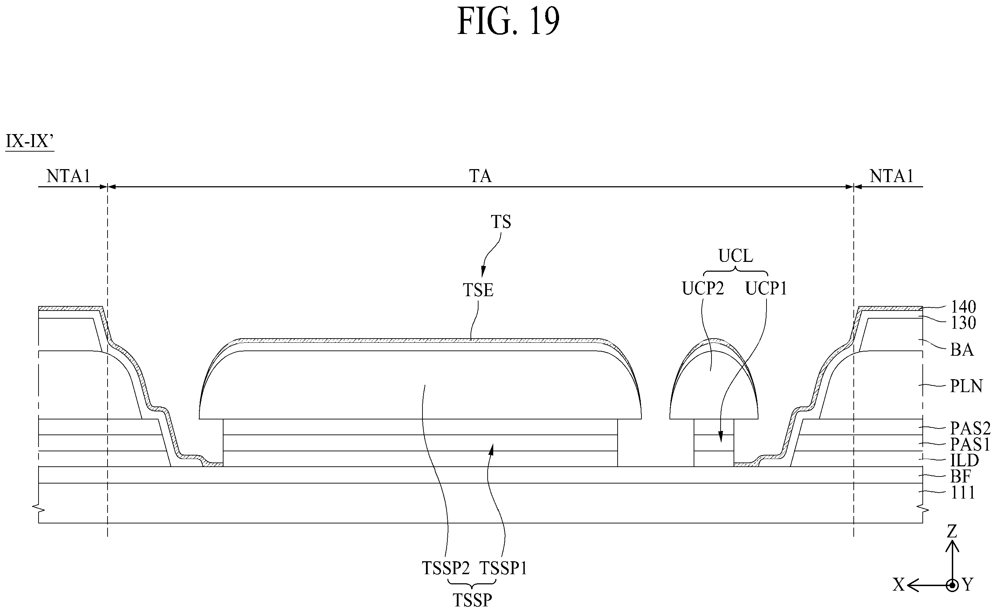

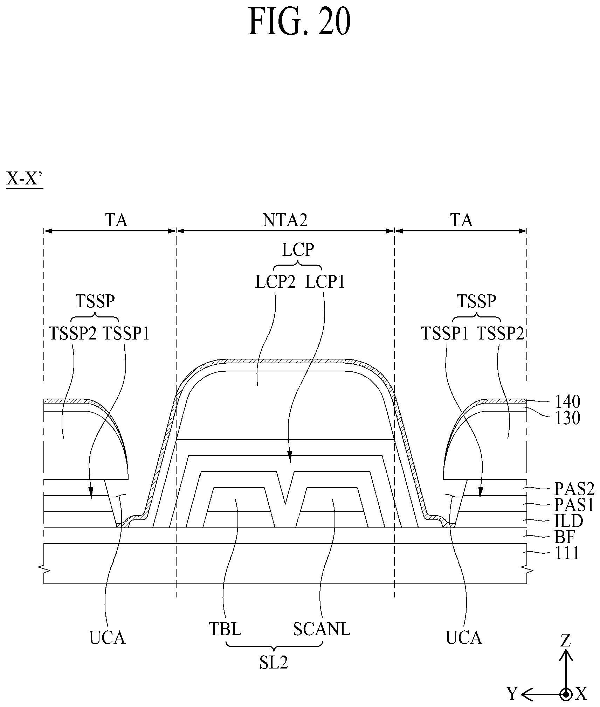

FIG. 18 is a view illustrating an area B shown in FIG. 3 according to another embodiment of the present disclosure. FIG. 19 is a cross-sectional view taken along line IX-IX' shown in FIG. 18 according to another embodiment of the present disclosure. FIG. 20 is a cross-sectional view taken along line X-X' shown in FIG. 18 according to another embodiment of the present disclosure. The elements of the undercut line in the transparent display panel 110 described with reference to FIGS. 1 to 17 are modified in FIGS. 18 to 20. Therefore, in the following description, the same reference numerals will be given to the other same elements except for the modified elements, and their redundant description will be omitted or briefly provided.

Referring to FIGS. 18 to 20, the transmissive area TA according to another embodiment of the present disclosure may include a touch sensor support portion TSSP and at least one undercut line UCL.

The touch sensor support portion TSSP may be disposed in the transmissive area TA. The touch sensor support portion TSSP may define the touch sensor TS in the transmissive area TA. The touch sensor support portion TSSP may be configured in an island pattern surrounding an area of the touch sensor TS. For example, the touch sensor support portion TSSP may include an undercut area at an edge portion thereof or along an edge of the touch sensor electrode TSE.

The touch sensor support portion TSSP may be configured so that the second electrode 140 extended from the light emitting element ED is separated or disconnected at the edge portion of the touch sensor support portion TSSP. The touch sensor TS may be formed above the touch sensor support portion TSSP. The touch sensor TS may include a touch sensor electrode TSE. The touch sensor support portion TSSP may separate or disconnect the second electrode 140 of the light emitting element ED by the undercut area of the edge portion thereof, so that the touch sensor electrode TSE having an island pattern may be configured on the touch sensor support portion TSSP.

The touch sensor support portion TSSP may not overlap the non-transmissive area NTA. The touch sensor support portion TSSP may not overlap at least one second signal line SL2 disposed in the second non-transmissive area NTA2, but the embodiments of the present disclosure are not limited thereto, and the touch sensor support portion TSSP may overlap at least one second signal line SL2. For example, although FIG. 18 shows that the touch sensor support portion TSSP is disposed in one transmissive area TA, the touch sensor support portion TSSP may be configured to be extend to at least one adjacent transmissive area TA. For example, the touch sensor support portion TSSP may be configured to be extended to the adjacent transmissive area TA through the second non-transmissive area NTA2. The touch sensor support portion TSSP may overlap at least one second signal line SL2. The block pattern BP may be disposed at a portion where the touch sensor support portion TSSP overlaps at least one second signal line SL2, but the embodiments of the present disclosure are not limited thereto.

At least one undercut line UCL may be disposed in the transmissive area TA, and may be disposed to be adjacent to the touch sensor TS configured by the touch sensor support portion TSSP. For example, at least one undercut line UCL may be disposed to be extended in the first direction (or Y-axis direction) in the transmissive area TA. At least one undercut line UCL may be configured to cross a plurality of transmissive areas TA arranged in parallel in the first direction. As at least one undercut line UCL is extended in the first direction, it may cross and overlap at least a portion of at least one second signal line SL2.

Referring to FIG. 19, the touch sensor support portion TSSP may be disposed in the transmissive area TA on the substrate 111. At least one undercut line UCL may be disposed to be adjacent to the touch sensor support portion TSSP in the transmissive area TA on the substrate 111.

In the touch sensor support portion TSSP, a first touch sensor support pattern TSSP1 may be provided by removing at least a portion of the interlayer insulating layer ILD, the first passivation layer PAS1 and the second passivation layer PAS2, and a second touch sensor support pattern TSSP2 may be provided by removing at least a portion of the planarization layer PLN on the first touch sensor support pattern TSSP1. The first touch sensor support pattern TSSP1 may be consisted of at least a portion of the at least one insulating layer, and the second touch sensor support pattern TSSP2 may be consisted of the planarization layer PLN. An edge portion of the second touch sensor support pattern TSSP2 may have an eave structure that is more protruded than the first touch sensor support pattern TSSP1. An undercut area may be included below the edge of the second touch sensor support pattern TSSP2.

The second electrode 140 of the light emitting element ED disposed on the touch sensor support portion TSSP is separated or disconnected from the second electrode140 of the light emitting element ED at the edge portion of the touch sensor support portion TSSP by the undercut area, whereby the touch sensor electrode TSE may be provided. The touch sensor electrode TSE may be provided in an island pattern on the touch sensor support portion TSSP.

In at least one undercut line UCL, a first undercut pattern UCP1 may be provided by removing at least a portion of the interlayer insulating layer ILD, the first passivation layer PAS1 and the second passivation layer PAS2, and a second undercut pattern UCP2 may be provided by removing at least a portion of the planarization layer PLN on the first undercut pattern UCP1. An edge portion of the second undercut pattern UCP2 may have an eave structure that is more protruded than the first undercut pattern UCP1. An undercut area may be included below the edge of the second undercut pattern UCP2.

At least one undercut line UCL may separate or disconnect the organic light emitting layer 130 extended from the adjacent light emitting element ED, and as the undercut line UCL is provided by removing at least a portion of the planarization layer PLN, the undercut line UCL may separate or disconnect the planarization layer PLN, which is an organic insulating layer. Therefore, at least one undercut line UCL may form a boundary line in which the organic light emitting layer 130 and the planarization layer PLN, which may serve as a moisture permeation path, are continuously removed in the first direction (or Y-axis direction), and permeation of moisture into one side or the other side based on the boundary line by at least one undercut line UCL may be avoided.

Referring to FIG. 20, at least one second signal line SL2 may be disposed in the second non-transmissive area NTA2 on the substrate 111. At least one second signal line SL2 may be extended in the second direction (or X-axis direction). At least one signal line SL2 may be protected by a line capping pattern LCP including at least one insulating layer and at least a portion of the planarization layer PLN in the second non-transmissive area NTA2 of the substrate 111. For example, the line capping pattern LCP may include a first line capping pattern LCP1 consisting of at least one insulating layer and a second line capping pattern LCP2 consisting of a planarization layer PLN on the first line capping pattern LCP2.

In the transparent display panel 110 according to another embodiment of the present disclosure, the touch sensor support portion TSSP and at least one undercut line UCL are provided in the transmissive area TA, so that the touch sensor TS may be provided in the transmissive area TA, and a boundary line in which the organic light emitting layer 130 and the planarization layer PLN, which may be a moisture permeation path, are continuously removed in one side direction (e.g., the first direction or the second direction) may be formed. Therefore, the outside of the boundary line by at least one undercut line UCL may be a cutting possible area capable of preventing moisture permeation toward the pixel P even though it is cut (or separated). Therefore, in the transparent display panel 110 according to another embodiment of the present disclosure, the cutting possible area by at least one undercut line UCL may be provided in the transmissive area TA, so that a cuttable transparent display panel, which may be manufactured by being divided into various sizes depending on the field to which the transparent display panel 110 is applied and the usage thereof, may be implemented or realized.

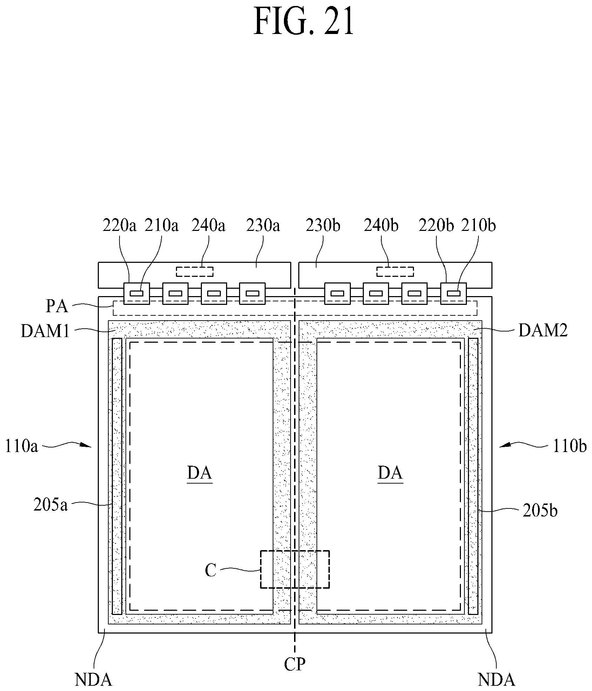

FIG. 21 is a cross-sectional view illustrating a transparent display apparatus according to another embodiment of the present disclosure.

Referring to FIG. 21, the transparent display panel 110 according to another embodiment of the present disclosure may include a display area DA in which pixels are provided to display an image and a non-display area NDA in which an image is not displayed.

The transparent display panel 110 according to another embodiment of the present disclosure may include at least one undercut line UCL extended from the non-display area NDA to the display area DA in the first direction (or Y-axis direction).

The transparent display panel 110 may include dam patterns DAM1 and DAM2 that divide the display area DA into at least two or more. The dam patterns DAM1 and DAM2 may be configured in the form of a closed loop surrounding at least a portion of the non-display area NDA (or bezel area) and the display area DA so that the display area DA may be divided into at least two or more. For example, the dam patterns DAM1 and DAM2 may include a first dam pattern DAM1 and a second dam pattern DAM2.

The first dam pattern DAM1 may be configured to surround the display area DA positioned on the left side in the second direction (or X-axis direction). The second dam pattern DAM2 may be configured to surround the display area DA positioned on the right side in the second direction (or X-axis direction).

The first dam pattern DAM1 and the second dam pattern DAM2 may be spaced apart from each other in the second direction (or X-axis direction). Alternatively, the first dam pattern DAM1 and the second dam pattern DAM2 may be disposed so that their adjacent portions at least partially overlap each other.

The transparent display panel 110 may include a plurality of gate drivers 205a and 205b. For example, the plurality of gate drivers 205a and 205b may include a first gate driver 205a and a second gate driver 205b. The first gate driver 205a may be disposed in the non-display area NDA positioned on the left side in the second direction (or X-axis direction), and the second gate driver 205b may be disposed in the non-display area NDA positioned on the right side in the second direction (or X-axis direction). For example, the first dam pattern DAM1 may be disposed to surround the first gate driver 205a and a left portion of the display area DA, and the second dam pattern DAM2 may be disposed to surround the second gate driver 205b and a right portion of the display area DA.

The transparent display panel 110 may include first and second source drive integrated circuits (hereinafter, referred to as "IC") 210a and 210b, first and second flexible films 220a and 220b, first and second circuit boards 230a and 230b, and first and second timing controllers 240a and 240b.

The first source drive IC 210a, the first flexible film 220a, the first circuit board 230a and the first timing controller 240a may be connected to the left display area DA defined by the first dam pattern DAM1, and the second source drive IC 210b, the second flexible film 220b, the second circuit board 230b and the second timing controller 240b may be connected to the right display area DA defined by the second dam pattern DAM2.

A cutting portion CP may be provided between the first dam pattern DAM1 and the second dam pattern DAM2. The cutting portion CP is a portion in which the transparent display panel 110 may be separated or cut through a cutting device such as a laser or a wheel. For example, the display areas DA surrounded by the first and second dam patterns DAM1 and DAM2 may be the display areas DA of the transparent display panels 110a and 110b independent of each other by being separated or cut by the cutting portion CP.

The first and second dam patterns DAM1 and DAM2 may be the non-display area NDA (or bezel area) of each of the separated transparent display panels 110a and 110b. For example, a center portion of the display area DA, in which the first and second dam patterns DAM1 and DAM2 cross in the first direction (or Y-axis direction), is the display area DA before cutting, but may be the non-display area NDA (or bezel area) after cutting.

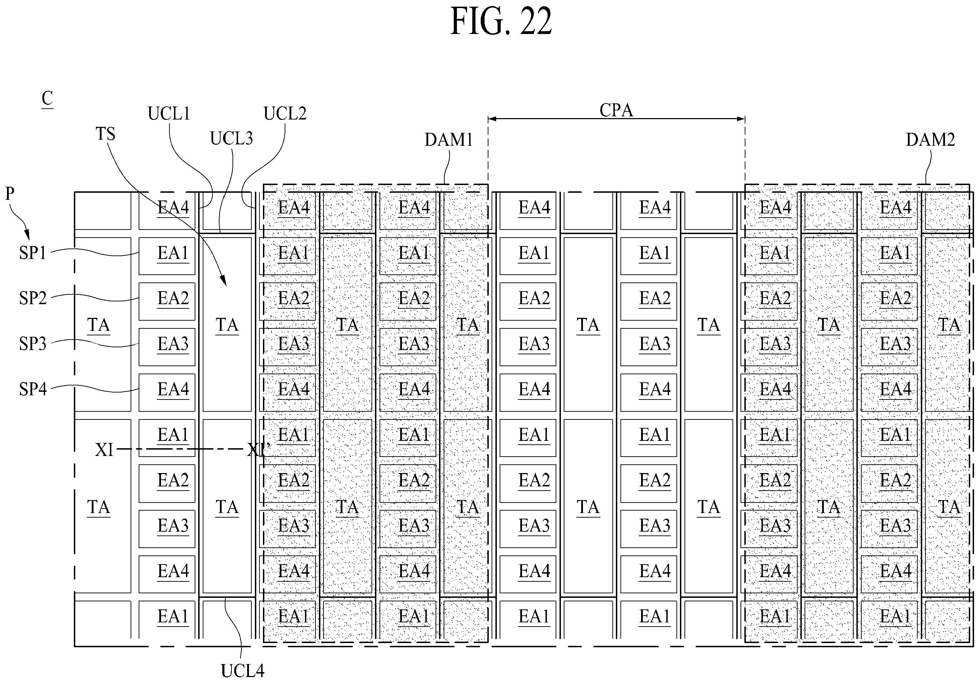

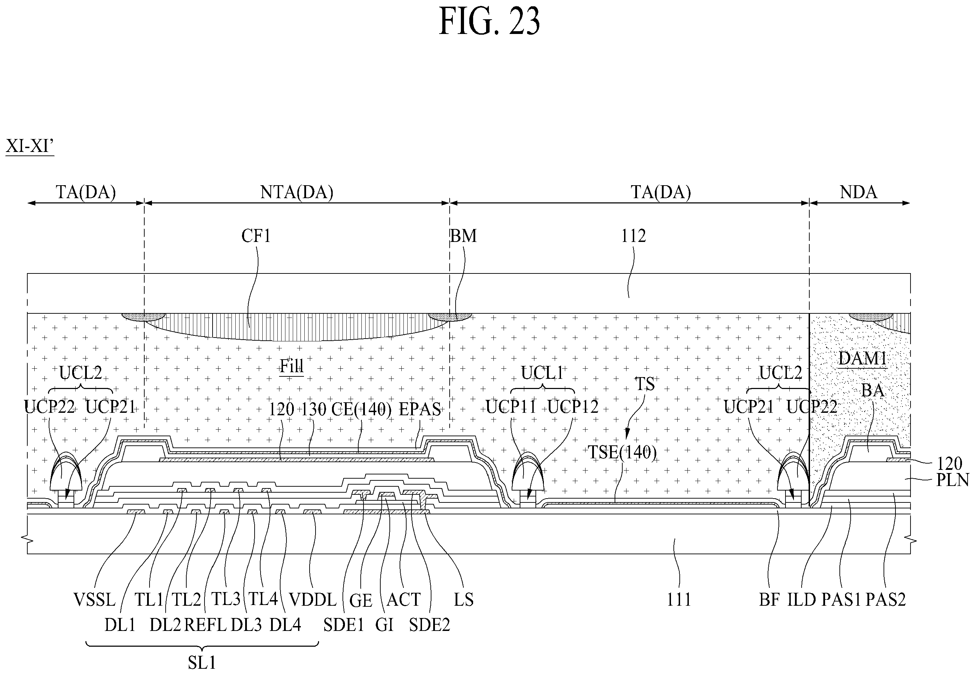

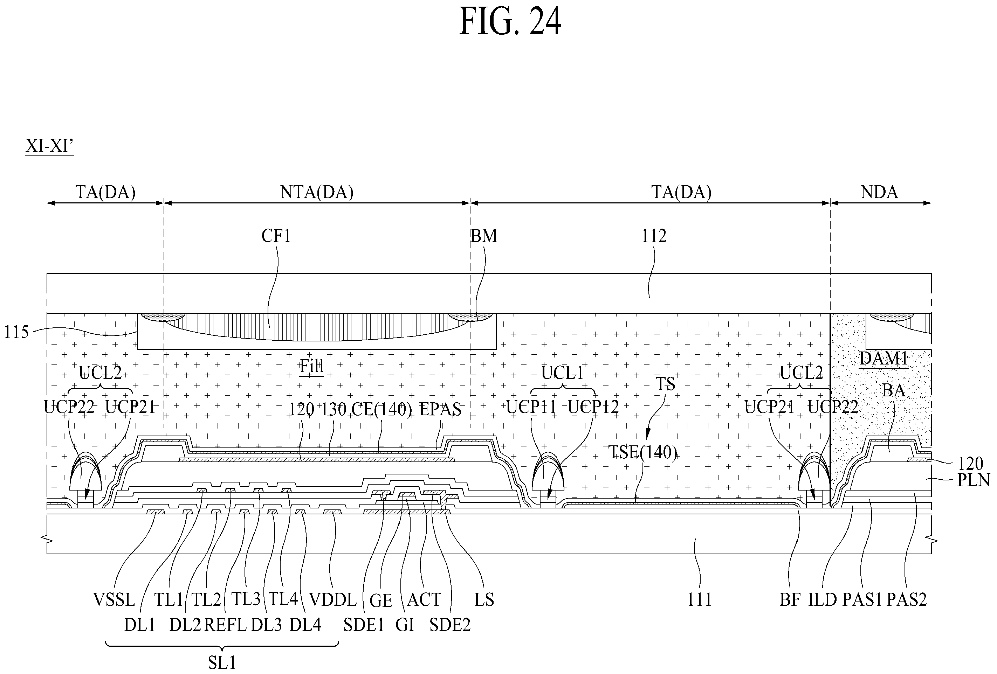

FIG. 22 is a view illustrating an area C shown in FIG. 21 according to another embodiment of the present disclosure. FIG. 23 is a cross-sectional view taken along line XI-XI' shown in FIG. 22 according to another embodiment of the present disclosure. FIG. 24 is a cross-sectional view taken along line XI-XI' shown in FIG. 22 according to another embodiment of the present disclosure.

Referring to FIGS. 22 to 24 in conjunction with FIG. 21, the transparent display panel 110 may include a plurality of transmissive areas TA disposed in parallel in the first direction (or Y-axis direction) and spaced apart from each other in the second direction (or X-axis direction). At least one undercut line UCL extended in the first direction (or Y-axis direction) may be disposed in each of the transmissive areas TA. At least one undercut line UCL may include a plurality of undercut lines UCL1, UCL2, UCL3 and UCL4. The plurality of undercut lines UCL1, UCL2, UCL3 and UCL4 may include a first undercut line UCL1, a second undercut line UCL2, a third undercut line UCL3 and a fourth undercut line UCL4.

The first to fourth undercut lines UCL1, UCL2, UCL3 and UCL4 may be connected to each other to form a touch electrode TS in the transmissive area TA, and the first and second undercut lines UCL1 and UCL2 may be extended continuously in the first direction (or Y-axis direction) to form an anti-moisture permeation boundary line.

A cutting possible area CPA may be provided between the first dam pattern DAM1 and the second dam pattern DAM2. Even though the transparent display panel 110 is cut, the cutting possible area CPA may be an area in which anti-moisture permeation reliability may be obtained by the first and second dam patterns DAM1 and DAM2 and the plurality of undercut lines UCL1, UCL2, UCL3 and UCL4.

The plurality of undercut lines UCL1, UCL2, UCL3 and UCL4 may be disposed in the entire area of the transparent display panel 110. The plurality of undercut lines UCL1, UCL2, UCL3 and UCL4 may be disposed to overlap the first and second dam patterns DAM1 and DAM2.

Referring to FIG. 23, the transparent display panel 110 according to another embodiment of the present disclosure may include a light shielding layer LS, a plurality of data lines DL1, DL2, DL3 and DL4, a reference line REFL, a pixel power line VDDL, a common power line VSSL, a buffer layer BF, an active layer ACT of a thin film transistor, a gate insulating layer GI, a gate electrode GE, a first source/drain electrode SDE1, a second source/drain electrode SDE2, an interlayer insulating layer ILD, a first passivation layer PAS1, a second passivation layer PAS2, a planarization layer PLN, a light emitting element ED, a bank layer BA, an encapsulation layer EPAS and the like, which are disposed on a first substrate 111. Also, the transparent display panel 110 may include color filter CF1 disposed on a second substrate (opposite substrate) 112 disposed to face the first substrate 111, and a black matrix BM. The first substrate 111 and the second substrate 112 may be bonded to each other by a connection member Fill.

The transparent display panel 110 according to another embodiment of the present disclosure may include a plurality of undercut lines UCL1, UCL2, UCL3 and UCL4 in the transmissive area TA.

The first and second undercut lines UCL1 and UCL2 of the plurality of undercut lines UCL1, UCL2, UCL3 and UCL4 may be disposed between the first dam pattern DAM1 and the light emitting element ED. The first and second undercut lines UCL1 and UCL2 may be disposed between the first dam pattern DAM1 and the light emitting element ED to prevent permeation of moisture that may be permeated through the first dam pattern DAM1. At least a portion of the dam pattern may be disposed in parallel with the at least one undercut line. The at least one undercut line may be disposed to be adjacent to and parallel with the dam pattern. Therefore, in the transparent display panel 110 according to another embodiment of the present disclosure, even though the cutting area CPA between the first dam pattern DAM1 and the second dam pattern DAM2 is cut by a cutting device such as a laser or a wheel, since permeation of moisture by at least one undercut line UCL may be avoided, a cuttable transparent display panel, which may be manufactured by being divided into various sizes depending on the field to which the transparent display panel 110 is applied and the usage thereof, may be implemented or realized.

Referring to FIG. 24, the transparent display panel 110 according to another embodiment of the present disclosure may further include a plurality of upper passivation layers 115 covering the color filter CF1 of the second substrate 112.

The plurality of upper passivation layers 115 may be disposed to be spaced apart from each other with the transmissive area TA of the display area DA, which is interposed therebetween. The plurality of upper passivation layers 115 may be provided to cover the color filter. For example, the plurality of upper passivation layers 115 may be provided to cover a plurality of color filters CF1 and CF2. Also, the plurality of upper passivation layers 115 may be provided to cover the plurality of color filters CF1 and CF2 and the black matrix BM. For example, the plurality of upper passivation layers 115 may be made of an organic material.

In the transparent display panel 110 according to another embodiment of the present disclosure, the plurality of undercut lines UCL1, UCL2, UCL3 and UCL4, which separate or disconnect the organic light emitting layer 130 on the first substrate 111, and the upper passivation layer 115 on the second substrate 112 may be disposed to be spaced apart from each other, so that the moisture permeation path through the second substrate 112 may be blocked.

According to another embodiment of the present disclosure, a dam pattern may be omitted between the first substrate 111 and the second substrate 112 of the transparent display panel 110, and the transparent display panel 110 may further include a side sealing member disposed at edge portions of the first substrate 111 and the second substrate 112. The side sealing member may serve to supplement anti-moisture permeation reliability by omission of the dam pattern.

A transparent display apparatus according to one or more embodiments of the present disclosure will be described below.

A transparent display apparatus according to one or more embodiments of the present disclosure may include a substrate including a non-transmissive area including a light emission area in which a light emitting element is disposed and a transmissive area, a plurality of first signal lines disposed in the non-transmissive area on the substrate and extended in a first direction, at least one second signal line disposed in the non-transmissive area on the substrate and extended in a second direction crossing the first direction, a touch sensor disposed in the transmissive area on the substrate, and at least one undercut line disposed to be adjacent to the touch sensor.

According to one or more embodiments of the present disclosure, the at least one undercut line may be extended to be adjacent to the touch sensor in the first direction or the second direction.

According to one or more embodiments of the present disclosure, the at least one undercut line may be disposed to be adjacent to the touch sensor in the transmissive area.

According to one or more embodiments of the present disclosure, the at least one undercut line may be extended in the first direction to cross the transmissive area.

According to one or more embodiments of the present disclosure, the at least one undercut line may cross and overlap at least a portion of the at least one second signal line.

According to one or more embodiments of the present disclosure, the at least one undercut line may be disposed to be adjacent to the touch sensor in the non-transmissive area.

According to one or more embodiments of the present disclosure, the at least one undercut line may be extended in the second direction to cross the non-transmissive area.

According to one or more embodiments of the present disclosure, the at least one undercut line may overlap at least a portion of the at least one second signal line in parallel.

According to one or more embodiments of the present disclosure, the touch sensor may include a touch sensor electrode provided in an island pattern.

According to one or more embodiments of the present disclosure, the touch sensor electrode may not overlap the at least one second signal line.

According to one or more embodiments of the present disclosure, the touch sensor electrode may be disposed in the transmissive area.

According to one or more embodiments of the present disclosure, the touch sensor electrode may overlap the at least one second signal line.

According to one or more embodiments of the present disclosure, the touch sensor electrode may be provided in at least two transmissive areas adjacent to each other in the first direction with the at least one second signal line interposed therebetween.

According to one or more embodiments of the present disclosure, the at least one undercut line may be provided to separate or disconnect an organic light emitting layer constituting the light emitting element.

According to one or more embodiments of the present disclosure, the light emitting element may include a first electrode, an organic light emitting layer and a second electrode, and the second electrode may include a cathode electrode constituting the light emitting element in the non-transmissive area and a touch sensor electrode constituting the touch sensor in the transmissive area.

According to one or more embodiments of the present disclosure, the at least one undercut line may be provided to separate or disconnect the cathode electrode from the touch sensor electrode.

According to one or more embodiments of the present disclosure, the transparent display device may further comprise a planarization layer on the substrate, and at least one insulating layer between the substrate and the planarization layer, wherein the at least one undercut line may be provided by removing at least a portion of the planarization layer and the at least one insulating layer.

According to one or more embodiments of the present disclosure, at least a portion of the at least one undercut line may cross and overlap the at least one second signal line, and the transparent display apparatus may further comprise a block pattern disposed at a portion where the at least one undercut line and the at least one second signal line cross each other.

According to one or more embodiments of the present disclosure, the block pattern may be between the at least one undercut line and the at least one second signal line.

According to one or more embodiments of the present disclosure, the at least one undercut line may include a first undercut line surrounding the touch sensor electrode in the transmissive area, and a second undercut line extended in the first direction to cross the transmissive area.

According to one or more embodiments of the present disclosure, the first undercut line may not overlap the at least one second signal line.

According to one or more embodiments of the present disclosure, at least a portion of the first undercut line may cross and overlap the at least one second signal line.

According to one or more embodiments of the present disclosure, the at least one undercut line may include first and second undercut lines spaced apart from each other in the second direction in the transmissive area with the touch sensor electrode interposed therebetween and extended in parallel in the first direction, and third and fourth undercut lines spaced apart from each other in the first direction with the touch sensor electrode interposed therebetween between the first undercut line and the second undercut line and extending in parallel in the second direction.

According to one or more embodiments of the present disclosure, each of the first undercut line and the second undercut line may cross and overlap the at least one second signal line.

According to one or more embodiments of the present disclosure, the third undercut line and the fourth undercut line may be connected to the first undercut line and the second undercut line.

According to one or more embodiments of the present disclosure, each of the third undercut line and the fourth undercut line may overlap the at least one second signal line in parallel.

According to one or more embodiments of the present disclosure, the transparent display apparatus may further comprise a touch sensor bridge pattern interposed between the third undercut line and the fourth undercut line and overlapped with the at least one second signal line in parallel.

According to one or more embodiments of the present disclosure, one end and the other end (e.g., opposite ends) of the touch sensor bridge pattern may be spaced apart from the first undercut line and the second undercut line.

According to one or more embodiments of the present disclosure, the touch sensor electrode may be provided in at least two transmissive areas adjacent to each other in the first direction with the at least one second signal line interposed therebetween by the touch sensor bridge pattern.

According to one or more embodiments of the present disclosure, the transmissive area may include a touch sensor support portion having an undercut area along an edge of the touch sensor electrode, and the at least one undercut line may be extended in the first direction to be adjacent to the touch sensor support portion to cross the transmissive area.

According to one or more embodiments of the present disclosure, the touch sensor support portion may not overlap the at least one second signal line.

According to one or more embodiments of the present disclosure, the touch sensor support portion may overlap the at least one second signal line.

According to one or more embodiments of the present disclosure, the transparent display apparatus may further comprise a block pattern disposed at a portion where the touch sensor support portion and the at least one second signal line overlap each other.

According to one or more embodiments of the present disclosure, the block pattern may be between the touch sensor support portion and the at least one second signal line.

According to one or more embodiments of the present disclosure, the touch sensor support portion may include a first support pattern consisting of at least a portion of the at least one insulating layer, and a second support pattern disposed on the first support pattern, and consisting of the planarization layer, and the undercut area of the touch sensor support portion may be provided so that that the second support pattern is more protruded than the first support pattern.

According to one or more embodiments of the present disclosure, the transparent display apparatus may further comprise an opposite substrate disposed to face the substrate, including a color filter disposed to correspond to the light emission area, and a connection member connecting the substrate with the opposite substrate.

According to one or more embodiments of the present disclosure, the substrate may include a display area and a non-display area near the display area, and the transparent display apparatus may further comprise a dam pattern positioned between the substrate and the opposite substrate and disposed in the non-display area on the substrate.

According to one or more embodiments of the present disclosure, the dam pattern may be provided in a closed loop surrounding the non-display area on the substrate.

According to one or more embodiments of the present disclosure, at least a portion of the dam pattern may be disposed in parallel with the at least one undercut line.

According to one or more embodiments of the present disclosure, the at least one undercut line may be disposed to overlap the dam pattern.

According to one or more embodiments of the present disclosure, the at least one undercut line may be disposed to be adjacent to and parallel with the dam pattern.

According to one or more embodiments of the present disclosure, the transparent display apparatus may further comprise a side sealing member provided to cover edges of the substrate and the opposite substrate.

According to one or more embodiments of the present disclosure, the opposite substrate may further include a plurality of upper passivation layers covering the color filter, and the upper passivation layers may be spaced apart from each other with the transmissive area interposed therebetween.

According to one or more embodiments of the present disclosure, the at least one undercut line may be configured in a form of a closed loop in which portions parallel in the first direction and extended to be spaced apart from each other in the second direction and portions parallel in the second direction and extended to be spaced apart from each other in the first direction are connected to each other.

According to one or more embodiments of the present disclosure, the first signal lines may include a touch line, and a touch sensor contact portion may be disposed inside the at least one undercut line, and the touch line and the touch sensor may be electrically connected to each other through the touch sensor contact portion.

According to one or more embodiments of the present disclosure, the at least one undercut line may include a first undercut pattern and a second undercut pattern, and the second undercut pattern may be formed to be more protruded than the first undercut pattern, and an undercut area may be included below an edge of the second undercut pattern.

According to one or more embodiments of the present disclosure, the at least one second signal line may be protected by a line capping pattern, and the line capping pattern may include a first line capping pattern consisting of the at least one insulating layer and a second line capping pattern consisting of the planarization layer on the first line capping pattern.

According to one or more embodiments of the present disclosure, the touch sensor electrode may be configured to cross the non-transmissive area between the adjacent transmissive areas without being separated or disconnected.

According to one or more embodiments of the present disclosure, the second electrode of the light emitting element disposed on the touch sensor support portion may be separated or disconnected from the second electrode of the light emitting element at an edge portion of the touch sensor support portion by the undercut area, so as to provide the touch sensor electrode.

According to one or more embodiments of the present disclosure, the touch sensor support portion may be configured in an island pattern surrounding an area of the touch sensor.

## Claims

1. A transparent display apparatus comprising:
a substrate (111) including a non-transmissive area (NTA) including a light emission area (EA) in which a light emitting element (ED) is disposed and a transmissive area (TA);
a plurality of first signal lines (SL1) disposed in the non-transmissive area (NTA) on the substrate (111) and extended in a first direction (Y);
at least one second signal line (SL2) disposed in the non-transmissive area (NTA) on the substrate (111) and extended in a second direction (X) crossing the first direction (Y);
a touch sensor (TS) disposed in the transmissive area (TA) on the substrate (111); and
at least one undercut line (UCL) disposed to be adjacent to the touch sensor (TS),
wherein the at least one undercut line (UCL) includes:
a first undercut line (UCL1) surrounding a touch sensor electrode (TSE) of the touch sensor (TS) in the transmissive area (TA); and
a second undercut line (UCL2) extended in the first direction (Y),
wherein the second undercut line (UCL2) crosses and overlaps the at least one second signal line (SL2),
wherein a block pattern (BP) disposed at a portion where the at least one undercut line (UCL) and the at least one second signal line (SL2) cross each other, and
wherein the at least one undercut line (UCL) is provided to separate or disconnect an organic light emitting layer (130) constituting the light emitting element (ED).

2. The transparent display apparatus of claim 1, wherein the at least one undercut line (UCL) is extended to be adjacent to the touch sensor (TS) in the first direction (Y) or the second direction (X).

3. The transparent display apparatus of claim 1 or 2, wherein the at least one undercut line (UCL) is disposed to be adjacent to the touch sensor (TS) in the transmissive area (TA).

4. The transparent display apparatus of claim 3, wherein the at least one undercut line (UCL) is extended in the first direction (Y) to cross the transmissive area (TA).

5. The transparent display apparatus of claim 4, wherein the at least one undercut line (UCL) crosses and overlaps at least a portion of the at least one second signal line (SL2).

6. The transparent display apparatus of claim 1 or 2, wherein the at least one undercut line (UCL) is disposed to be adjacent to the touch sensor (TS) in the non-transmissive area (NTA).

7. The transparent display apparatus of claim 6, wherein the at least one undercut line (UCL) is extended in the second direction (X) to cross the non-transmissive area (NTA).

8. The transparent display apparatus of claim 7, wherein the at least one undercut line (UCL) overlaps at least a portion of the at least one second signal line (SL2) in parallel.

9. The transparent display apparatus of any of claims 1 to 8, wherein the touch sensor (TS) includes a touch sensor electrode (TSE) provided in an island pattern.

10. The transparent display apparatus of claim 9, wherein the touch sensor electrode (TSE) does not overlap the at least one second signal line (SL2).

11. The transparent display apparatus of claim 9 or 10, wherein the touch sensor electrode (TSE) is disposed in the transmissive area (TA).

12. The transparent display apparatus of claim 9, wherein the touch sensor electrode (TSE) overlaps the at least one second signal line (SL2), or
wherein the touch sensor electrode (TSE) is provided in at least two transmissive areas (TA) adjacent to each other in the first direction (Y) with the at least one second signal line (SL2) interposed therebetween.

13. The transparent display apparatus of any of claims 1 to 12, wherein:
the light emitting element (ED) includes a first electrode, an organic light emitting layer (130) and a second electrode; and
the second electrode includes a cathode electrode constituting the light emitting element (ED) in the non-transmissive area (NTA) and a touch sensor electrode (TSE) constituting the touch sensor (TS) in the transmissive area (TA).

14. The transparent display apparatus of claim 13,
wherein the at least one undercut line (UCL) is provided to separate or disconnect the cathode electrode from the touch sensor electrode (TSE).

15. The transparent display apparatus of claim 13 or 14, further comprising:
a planarization layer (PLN) on the substrate (111); and
at least one insulating layer between the substrate (111) and the planarization layer (PLN),
wherein the at least one undercut line (UCL) is provided by removing at least a portion of the planarization layer (PLN) and the at least one insulating layer.

## Patentansprüche

1. Transparente Anzeigevorrichtung, aufweisend:
ein Substrat (111), aufweisend einen nicht-transmissiven Bereich (NTA), der einen Lichtemissionsbereich (EA) aufweist, in dem ein lichtemittierendes Element (ED) angeordnet ist, und einen transmissiven Bereich (TA);
eine Mehrzahl von ersten Signalleitungen (SL1), die in dem nicht-transmissiven Bereich (NTA) auf dem Substrat (111) angeordnet sind und sich in einer ersten Richtung (Y) erstrecken;
mindestens eine zweite Signalleitung (SL2), die im nicht-transmissiven Bereich (NTA) auf dem Substrat (111) angeordnet ist und sich in einer zweiten Richtung (X) erstreckt, die die erste Richtung (Y) kreuzt;
einen Berührungssensor (TS), der im transmissiven Bereich (TA) auf dem Substrat (111) angeordnet ist; und
mindestens eine Unterschnittleitung (UCL), die benachbart zum Berührungssensor (TS) angeordnet ist,
wobei die mindestens eine Unterschnittleitung (UCL) aufweist:
eine erste Unterschnittleitung (UCL1), die eine Berührungssensorelektrode (TSE) des Berührungssensors (TS) im transmissiven Bereich (TA) umgibt; und
eine zweite Unterschnittleitung (UCL2), die sich in der ersten Richtung (Y) erstreckt,
wobei die zweite Unterschnittleitung (UCL2) die mindestens eine zweite Signalleitung (SL2) kreuzt und überlappt,
wobei ein Blockmuster (BP) an einem Abschnitt angeordnet ist, an dem die mindestens eine Unterschnittleitung (UCL) und die mindestens eine zweite Signalleitung (SL2) einander kreuzen, und
wobei die mindestens eine Unterschnittleitung (UCL) bereitgestellt ist, um eine organische lichtemittierende Schicht (130), die das lichtemittierende Element (ED) bildet, zu trennen oder zu unterbrechen.

2. Transparente Anzeigevorrichtung gemäß Anspruch 1, wobei die mindestens eine Unterschnittleitung (UCL) sich erstreckt, um in der ersten Richtung (Y) oder der zweiten Richtung (X) benachbart zu dem Berührungssensor (TS) zu sein.

3. Transparente Anzeigevorrichtung gemäß Anspruch 1 oder 2, wobei die mindestens eine Unterschnittleitung (UCL) angeordnet ist, um im transmissiven Bereich (TA) zu dem Berührungssensor (TS) benachbart zu sein.

4. Transparente Anzeigevorrichtung gemäß Anspruch 3, wobei die mindestens eine Unterschnittleitung (UCL) sich in der ersten Richtung (Y) erstreckt, um den transmissiven Bereich (TA) zu kreuzen.

5. Transparente Anzeigevorrichtung gemäß Anspruch 4, wobei die mindestens eine Unterschnittleitung (UCL) mindestens einen Abschnitt der mindestens einen zweiten Signalleitung (SL2) kreuzt und überlappt.

6. Transparente Anzeigevorrichtung gemäß Anspruch 1 oder 2, wobei die mindestens eine Unterschnittleitung (UCL) angeordnet ist, um im nicht-transmissiven Bereich (NTA) zu dem Berührungssensor (TS) benachbart zu sein.

7. Transparente Anzeigevorrichtung gemäß Anspruch 6, wobei die mindestens eine Unterschnittleitung (UCL) sich in der zweiten Richtung (X) erstreckt, um den nicht-transmissiven Bereich (NTA) zu kreuzen.

8. Transparente Anzeigevorrichtung gemäß Anspruch 7, wobei die mindestens eine Unterschnittleitung (UCL) mindestens einen Abschnitt der mindestens einen zweiten Signalleitung (SL2) parallel überlappt.

9. Transparente Anzeigevorrichtung gemäß irgendeinem der Ansprüche 1 bis 8, wobei der Berührungssensor (TS) eine Berührungssensorelektrode (TSE) aufweist, die in einem Inselmuster bereitgestellt ist.

10. Transparente Anzeigevorrichtung gemäß Anspruch 9, wobei die Berührungssensorelektrode (TSE) die mindestens eine zweite Signalleitung (SL2) nicht überlappt.

11. Transparente Anzeigevorrichtung gemäß Anspruch 9 oder 10, wobei die Berührungssensorelektrode (TSE) im transmissiven Bereich (TA) angeordnet ist.

12. Transparente Anzeigevorrichtung gemäß Anspruch 9, wobei die Berührungssensorelektrode (TSE) die mindestens eine zweite Signalleitung (SL2) überlappt, oder
wobei die Berührungssensorelektrode (TSE) in mindestens zwei transmissiven Bereichen (TA) benachbart zueinander in der ersten Richtung (Y) bereitgestellt ist, wobei die mindestens eine zweite Signalleitung (SL2) dazwischen angeordnet ist.

13. Transparente Anzeigevorrichtung gemäß irgendeinem der Ansprüche 1 bis 12, wobei:
das lichtemittierende Element (ED) eine erste Elektrode, eine organische lichtemittierende Schicht (130) und eine zweite Elektrode aufweist; und
die zweite Elektrode eine Kathodenelektrode, die das lichtemittierende Element (ED) im nicht-transmissiven Bereich (NTA) bildet, und eine Berührungssensorelektrode (TSE), die den Berührungssensor (TS) im transmissiven Bereich (TA) bildet, aufweist.

14. Transparente Anzeigevorrichtung gemäß Anspruch 13,
wobei die mindestens eine Unterschnittleitung (UCL) bereitgestellt ist, um die Kathodenelektrode von der Berührungssensorelektrode (TSE) zu trennen oder zu unterbrechen.

15. Transparente Anzeigevorrichtung gemäß Anspruch 13 oder 14, ferner aufweisend:
eine Planarisierungsschicht (PLN) auf dem Substrat (111); und
mindestens eine Isolierschicht zwischen dem Substrat (111) und der Planarisierungsschicht (PLN),
wobei die mindestens eine Unterschnittleitung (UCL) durch Entfernen mindestens eines Abschnitts der Planarisierungsschicht (PLN) und der mindestens einen Isolierschicht bereitgestellt ist.

## Revendications

1. Dispositif d'affichage transparent, comprenant :
un substrat (111) comportant une zone non transmissive (NTA) comprenant une zone électroluminescente (EA) dans laquelle est disposé un élément électroluminescent (ED) et une zone transmissive (TA) ;
une pluralité de premières lignes de signal (SL1) disposées dans la zone non transmissive (NTA) sur le substrat (111) et s'étendant dans une première direction (Y) ;
au moins une deuxième ligne de signal (SL2) disposée dans la zone non transmissive (NTA) sur le substrat (111) et s'étendant dans une deuxième direction (X) croisant la première direction (Y) ;
un capteur tactile (TS) disposé dans la zone transmissive (TA) sur le substrat (111) ; et
au moins une ligne en contre-dépouille (UCL) disposée de manière à être adjacente au capteur tactile (TS),
dans lequel ladite au moins une ligne en contre-dépouille (UCL) comprend :
une première ligne en contre-dépouille (UCL1) entourant une électrode de capteur tactile (TSE) du capteur tactile (TS) dans la zone transmissive (TA) ; et
une deuxième ligne en contre-dépouille (UCL2) s'étendant dans la première direction (Y),
dans lequel la deuxième ligne en contre-dépouille (UCL2) croise et chevauche ladite au moins une deuxième ligne de signal (SL2),
dans lequel un motif en bloc (BP) est disposé au niveau d'une partie où ladite au moins une ligne en contre-dépouille (UCL) et ladite au moins une deuxième ligne de signal (SL2) se croisent, et
dans lequel ladite au moins une ligne de contre-dépouille (UCL) est prévue pour séparer ou déconnecter une couche électroluminescente organique (130) constituant l'élément électroluminescent (ED).

2. Dispositif d'affichage transparent selon la revendication 1, dans lequel ladite au moins une ligne en contre-dépouille (UCL) s'étend de manière à être adjacente au capteur tactile (TS) dans la première direction (Y) ou la deuxième direction (X).

3. Dispositif d'affichage transparent selon la revendication 1 ou 2, dans lequel ladite au moins une ligne en contre-dépouille (UCL) est disposée de manière à être adjacente au capteur tactile (TS) dans la zone transmissive (TA).

4. Dispositif d'affichage transparent selon la revendication 3, dans lequel ladite au moins une ligne en contre-dépouille (UCL) s'étend dans la première direction (Y) de manière à croiser la zone de transmission (TA).

5. Dispositif d'affichage transparent selon la revendication 4, dans lequel ladite au moins une ligne en contre-dépouille (UCL) croise et chevauche au moins une partie de ladite au moins une deuxième ligne de signal (SL2).

6. Dispositif d'affichage transparent selon la revendication 1 ou 2, dans lequel ladite au moins une ligne en contre-dépouille (UCL) est disposée de manière à être adjacente au capteur tactile (TS) dans la zone non transmissive (NTA).

7. Dispositif d'affichage transparent selon la revendication 6, dans lequel ladite au moins une ligne en contre-dépouille (UCL) s'étend dans la deuxième direction (X) pour croiser la zone non transmissive (NTA).

8. Dispositif d'affichage transparent selon la revendication 7, dans lequel ladite au moins une ligne en contre-dépouille (UCL) chevauche au moins une partie de ladite au moins une deuxième ligne de signal (SL2) en parallèle.

9. Dispositif d'affichage transparent selon l'une quelconque des revendications 1 à 8, dans lequel le capteur tactile (TS) comprend une électrode de capteur tactile (TSE) prévue selon un motif en îlot.

10. Dispositif d'affichage transparent selon la revendication 9, dans lequel l'électrode de capteur tactile (TSE) ne chevauche pas ladite au moins une deuxième ligne de signal (SL2).

11. Dispositif d'affichage transparent selon la revendication 9 ou 10, dans lequel l'électrode de capteur tactile (TSE) est disposée dans la zone transmissive (TA).

12. Dispositif d'affichage transparent selon la revendication 9, dans lequel l'électrode de capteur tactile (TSE) chevauche ladite au moins une deuxième ligne de signal (SL2), ou
dans lequel l'électrode de capteur tactile (TSE) est prévue dans au moins deux zones transmissives (TA) adjacentes l'une à l'autre dans la première direction (Y), ladite au moins une deuxième ligne de signal (SL2) étant intercalée entre elles.

13. Dispositif d'affichage transparent selon l'une quelconque des revendications 1 à 12, dans lequel :
l'élément électroluminescent (ED) comprend une première électrode, une couche électroluminescente organique (130) et une deuxième électrode ; et
la deuxième électrode comprend une électrode cathodique constituant l'élément électroluminescent (ED) dans la zone non transmissive (NTA) et une électrode de capteur tactile (TSE) constituant le capteur tactile (TS) dans la zone transmissive (TA).

14. Dispositif d'affichage transparent selon la revendication 13,
dans lequel ladite au moins une ligne en contre-dépouille (UCL) est prévue pour séparer ou déconnecter l'électrode cathodique de l'électrode de capteur tactile (TSE) .

15. Dispositif d'affichage transparent selon la revendication 13 ou 14, comprenant en outre :
une couche de planarisation (PLN) sur le substrat (111) ; et
au moins une couche isolante entre le substrat (111) et la couche de planarisation (PLN),
dans lequel ladite au moins une ligne en contre-dépouille (UCL) est prévue en retirant au moins une partie de la couche de planarisation (PLN) et de ladite au moins une couche isolante.
